# EUROPÄISCHE PATENTSCHRIFT

(11) **EP 3 282 270 B1**
(45) Veröffentlichungstag und Bekanntmachung des Hinweises auf die Patenterteilung: **06.05.2020**
(21) Anmeldenummer: 17185261.9
(22) Anmeldetag: 08.08.2017
(51) Int. Cl.: G01R 33/38, G01R 33/34, H01F 6/04, G01R 33/3815

(54) **NMR-APPARATUR MIT SUPRALEITENDER MAGNETANORDNUNG SOWIE GEKÜHLTEN PROBENKOPFKOMPONENTTEN**
NMR APPARATUS WITH SUPERCONDUCTING MAGNET ASSEMBLY AND COOLED SAMPLE HEAD COMPONENTS
APPAREIL RMN POURVU D'UN SYSTÈME D'AIMANTS SUPRACONDUCTEURS ET COMPOSANTS FORMANT SONDES REFROIDIS

(30) Priorität: 09.08.2016 DE 102016214731
(43) Veröffentlichungstag der Anmeldung: 14.02.2018
(73) Patentinhaber: Bruker Switzerland AG, 8117 Fällanden (CH)
(72) Erfinder: Hinderer, Jörg, 79761 Waldshut-Tiengen (DE); Schauwecker, Robert, 8004 Zürich (CH)
(74) Vertreter: Kohler Schmid Möbus Patentanwälte

(56) Entgegenhaltungen:
- EP-A1- 1 655 616
- DE-A1-102005 041 383

## Beschreibung

Die Erfindung betrifft eine NMR-Apparatur mit einer supraleitenden Magnetanordnung mit einem Kryostaten, welcher einen Vakuumbehälter und eine auf einer Betriebstemperatur < 100 K betreibbare Kältestufe umfasst, und mit einem supraleitenden Magnetspulensystem mit einer Kaltbohrung, in die ein Raumtemperaturzugang des Kryostaten eingreift, wobei im Betrieb ein NMR-Probenkopf mit auf eine Betriebstemperatur < 100 K gekühlten Probenkopfkomponenten vorhanden ist, wobei ein mindestens zweistufiger Kryokühler mit einer zweiten Kühlstufe auf einer Betriebstemperatur < 35,4 K und einer ersten Kühlstufe mit einer Betriebstemperatur über der Betriebstemperatur der zweiten Kühlstufe in einem wärmeisolierten Gehäuse angeordnet ist, wobei im wärmeisolierten Gehäuse ein Gegenstromwärmetauscher mit zwei Eingängen und zwei Ausgängen für zwei gegenläufige Kühlfluidströme vorhanden ist, wobei eine Kühlleitung Kühlfluid von einem Wärmetauscher auf der ersten Kühlstufe des Kryokühlers -direkt oder indirekt- in den ersten Eingang des Gegenstromwärmetauschers leitet, wobei eine Kühlleitung Kühlfluid vom zweiten Ausgang des Gegenstromwärmetauschers -direkt oder indirekt- zu einem Wärmetauscher auf der zweiten Kühlstufe des Kryokühlers leitet, wobei eine Kühlleitung Kühlfluid zu einer gekühlten Probenkopfkomponente oder zu einem Wärmetauscher auf einer gekühlten Probenkopfkomponente leitet, und wobei eine Kühlleitung Kühlfluid zu einem Wärmetauscher im Kryostatvakuum leitet.

Eine solche Anordnung ist etwa bekannt aus EP 1 655 616 A1 oder aus US 2006/0096301 A1 (Referenz [1]).

### Hintergrund der Erfindung

Das Einsatzgebiet der vorliegenden Erfindung bildet ein kryogenes System zur Kühlung eines supraleitenden Magnetspulensystems sowie zur Kühlung von Komponenten eines NMR-Probenkopfs beispielsweise für Anwendungen der Magnetresonanzspektroskopie (=NMR) oder der Magnetresonanztomographie (=MRI). Die Anwendbarkeit der Erfindung ist jedoch nicht auf dieses Gebiet beschränkt.

Supraleitende Magnetspulensysteme werden in einem Kryostaten betrieben, um die Temperatur unterhalb der Sprungtemperatur des Supraleiters zu halten. Typischerweise umfasst der Kryostat einen Vakuumbehälter, worin ein oder mehrere Kryobehälter mit je einem Kühlfluid, beispielsweise Flüssighelium oder Flüssigstickstoff, angeordnet sind. Das supraleitende Magnetspulensystem ist im kältesten Kryobehälter eingebaut. Damit ergibt sich eine sehr temperaturstabile und gleichmäßige Kühlung des supraleitenden Magnetspulensystems. Solche badgekühlten Systeme sind üblich für beispielsweise NMR-Spektrometer. Bei diesen Systemen müssen die Kühlfluide in regelmäßigen Zeitintervallen nachgefüllt werden, da der Wärmeeintrag auf die Kryobehälter für ein stetiges Verdampfen der Kühlfluide sorgt. Alternativ dazu können die Kühlfluide durch einen Kryokühler am Kryostaten verflüssigt werden, oder die Kühlung erfolgt durch thermische Anbindung des supraleitenden Magnetspulensystems und/oder eines oder mehrerer Strahlungsschilde des Kryostaten an eine Kühlstufe eines Kryokühlers.

Zum Einbau eines NMR-Probenkopfs verfügt der Vakuumbehälter des Kryostaten typischerweise über einen Raumtemperaturzugang in die Kaltbohrung des supraleitenden Magnetspulensystems. Weil sich der Betrieb des NMR-Probenkopfs auf Raumtemperatur nachteilig auf die Signalqualität auswirkt, werden NMR-Probenköpfe mit gekühlten Komponenten eingesetzt. Es sind verschiedene Ausführungsformen solcher NMR-Kryoprobenköpfe bekannt.

Üblicherweise werden NMR-Kryoprobenköpfe demontierbar im Raumtemperaturzugang des Kryostaten angebracht, wobei die gekühlten Komponenten dann in einem eigenen Isolationsbehälter angeordnet sind und über einen Kühlkreislauf gekühlt werden. Es sind aber auch NMR-Kryoprobenköpfe bekannt, welche mindestens teilweise fest im Isolationsvakuum des Kryostaten montiert sind.

### Stand der Technik

Verschiedene kryogene Systeme zur Kühlung eines supraleitenden Magnetspulensystems und zur Kühlung von Komponenten eines NMR-Probenkopfs sind bekannt, welche sich insbesondere hinsichtlich der mechanischen Integration von Magnetanordnung und NMR-Probenkopf zu einer apparativen Einheit und hinsichtlich der gemeinsamen Nutzung von Komponenten des kryogenen Systems zur Kühlung des Magnetspulensystems und des NMR-Probenkopfs unterscheiden.

In US 2012/0242335 A1 (Referenz [2]), US 2007/0107445 A1 (Referenz [3]), US 2005/0202976 A1 (Referenz [4]) und US 2006/0130493 A1 (Referenz [5]) sind Anordnungen offenbart mit einem im Raumtemperaturzugang des Kryostaten der Magnetanordnung demontierbar angebrachten NMR-Kryoprobenkopf.

In US 2007/0107445 A1, US 2005/0202976 A1 und US 2006/0130493 A1 werden der NMR-Kryoprobenkopf und Teile des Kryostaten der Magnetanordnung über einen gemeinsam genutzten Kryokühler gekühlt.

In US 2007/0107445 A1 und US 2005/0202976 A1 wird Heliumgas aus dem Kryostaten einer supraleitenden Magnetanordnung mit einem Kryokühler am Heliumgasauslass des Kryostaten verflüssigt. Der Kryokühler kühlt über Wärmetauscher auch den Kühlkreislauf eines NMR-Kryoprobenkopfs. In US 2006/0130493 A1 ist ein Kryokühler in einem Halsrohr am Kryostaten einer supraleitenden Magnetanordnung angebracht. Das Halsrohr kommuniziert mit dem Heliumbehälter des Kryostaten. Heliumgas aus dem Halsrohr wird durch einen Kühlkreislauf in einen NMR-Kryoprobenkopf geleitet. Am unteren (kältesten) Ende des Halsrohrs wird Heliumgas verflüssigt und fließt in den Heliumbehälter des Kryostaten zurück.

Die Nachteile dieser drei Anordnungen sind ein hoher Kühlaufwand, weil die kälteste Stufe des Kryokühlers unterhalb der Siedetemperatur von Flüssighelium (4.2 K) betrieben werden muss, und die Übertragung von Kühlervibrationen auf den Kryostaten, weil der Kryokühler direkt am Heliumgasauslass des Kryostaten angebracht ist. Vibrationen können NMR-Messungen stören.

In US 2012/0242335 A1 wird der NMR-Kryoprobenkopf über einen Kühlkreislauf gekühlt, welcher thermisch an ein Kältereservoir des Kryostaten der Magnetanordnung angebunden ist, beispielsweise an einen Stickstoffbehälter. Ein Nachteil dieser Anordnung ist, dass der Verbrauch von kryogenen Flüssigkeiten des Kryostaten erhöht wird.

DE 10 2013 213 020 A1 (Referenz [6]) offenbart ein Verfahren zum Umrüsten einer Kryostatanordnung auf Umlaufkühlung und zielt auf einen möglichst ökonomischen Betrieb eines tiefkalten Supraleitersystems ab.

DE 40 39 129 A1 (Referenz [7]) beschreibt ebenfalls eine Anwendung, die auf einem umlaufenden Fluid zur Kühlung beruht, insbesondere eine Einrichtung zur Kühlung einer SQUID-Messvorrichtung.

Eine Anordnung gemäß US 2012/0319690 A1 (Referenz [6]) weist einen im Vakuumbehälter des Kryostaten der supraleitenden Magnetanordnung eingebauten NMR-Kryoprobenkopf auf. Nachteilig bei dieser Anordnung ist der Verlust der mechanischen Modularität von Magnetanordnung und NMR-Kryoprobenkopf. Um den NMR-Kryoprobenkopf auszuwechseln, beispielsweise bei einem Defekt oder für die Durchführung von NMR-Messungen mit unterschiedlichen Anforderungen an den Funktionsumfang des NMR-Kryoprobenkopfs, muss das Kryostatvakuum gebrochen werden. Der NMR-Probenkopfwechsel bedingt also ein Entladen des supraleitenden Magnetspulensystems und ein Aufwärmen der Magnetanordnung.

Die Anordnung nach EP 1 655 616 A1 oder US 2006/0096301 A1 schließlich offenbart eine NMR-Apparatur mit folgenden Merkmalen:
- supraleitende Magnetanordnung
- Kryostat mit Vakuumbehälter
- supraleitendes Magnetspulensystem mit einer Kaltbohrung, in die ein Raumtemperaturzugang des Kryostaten eingreift
- NMR-Kryoprobenkopf im Raumtemperaturzugang oder in der Kaltbohrung
- NMR-Kryoprobenkopf mit auf eine Betriebstemperatur < 100 K gekühlten Probenkopfkomponenten
- mindestens zweistufiger Kryokühler mit der kältesten Kühlstufe auf einer Betriebstemperatur < 30 K
- Kryokühler im räumlichen Abstand zum Kryostaten in einem separaten, evakuierten und wärmeisolierten
   Gehäuse angeordnet
- Kühlkreislauf mit thermisch isolierten Kühlleitungen zwischen dem wärmeisolierten Gehäuse und dem NMR-Kryoprobenkopf.

Ein zweistufiger Kryokühler befindet sich in einem wärmeisolierten Gehäuse und kühlt über Wärmetauscher den Kühlkreislauf eines NMR-Kryoprobenkopfs und stellt auf der ersten (wärmeren) Kühlstufe überschüssige Kühlleistung zur Verflüssigung von Stickstoffgas aus dem Stickstoffbehälter eines Kryostaten oder zur Kühlung eines Strahlungsschildes eines Kryostaten einer supraleitenden Magnetanordnung zur Verfügung. Ein Nachteil dieser Anordnung ist, dass die Kühlleistung des Kryokühlers nicht zur Verringerung der Abdampfrate von tiefersiedenden kryogenen Flüssigkeiten, beispielsweise Flüssighelium, genutzt werden kann, weil die Temperatur der ersten Kühlstufe des Kryokühlers dafür zu hoch ist (ca. 35 K).

### Aufgabe der Erfindung

Der vorliegenden Erfindung liegt demgegenüber die Aufgabe zugrunde, eine NMR-Apparatur der eingangs beschriebenen Art mit einem supraleitenden Magnetspulensystem in einem Kryostaten und mit einem NMR-Kryoprobenkopf mit möglichst einfachen technischen Mitteln dahingehend zu verbessern, dass mit überschüssiger Kühlleistung eines Kryokühlers, welcher den Kühlkreislauf eines NMR-Kryoprobenkopfs kühlt, die Abdampfrate von Flüssighelium aus einem Kryostaten einer supraleitenden Magnetanordnung vermindert oder ein supraleitendes Magnetspulensystem in einem kryogenfreien Kryostaten gekühlt werden kann.

### Kurze Beschreibung der Erfindung

Diese Aufgabe wird erfindungsgemäß auf ebenso überraschend einfache wie wirkungsvolle Weise sowie mit ohne Weiteres zur Verfügung stehenden technischen Mitteln dadurch gelöst, dass ein Wärmetauscher, welcher im Kryostatvakuum oder in einem Aufhängerohr des Heliumbehälters des Kryostaten einer supraleitenden Magnetanordnung angeordnet ist, in jenem Abschnitt des Kühlkreislaufs eines NMR-Kryoprobenkopfs an den Kühlkreislauf angeschlossen ist, in welchem das Kühlfluid Wärme an die zweite Kühlstufe des Kryokühlers abgibt und welcher von jenem Abschnitt, in welchem das Kühlfluid Wärme an die erste Kühlstufe des Kryokühlers abgibt, durch einen Gegenstromwärmetauscher abgegrenzt ist. Insbesondere leitet eine Kühlleitung des Kühlkreislaufs eines NMR-Kryoprobenkopfs Kühlfluid - entweder direkt vom zweiten Ausgang des Gegenstromwärmetauschers oder indirekt vom zweiten Ausgang des Gegenstromwärmetauschers über den Wärmetauscher auf der zweiten Kühlstufe des Kryokühlers oder über eine gekühlte Probenkopfkomponente oder über einen Wärmetauscher auf einer gekühlten Probenkopfkomponente- zum Wärmetauscher im Kryostatvakuum oder zu einem Wärmetauscher in einem Aufhängerohr eines Heliumbehälters des Kryostaten und von diesem - entweder direkt oder indirekt über mindestens einen Wärmetauscher auf der zweiten Kühlstufe des Kryokühlers oder über eine gekühlte Probenkopfkomponente oder über den Wärmetauscher auf einer gekühlten Probenkopfkomponente- zum zweiten Eingang des Gegenstromwärmetauschers, so dass sowohl die Einlauftemperatur des in den Wärmetauscher im Kryostatvakuum oder in den Wärmetauscher in einem Aufhängerohr des Heliumbehälters des Kryostaten einströmenden Kühlfluids des Kühlkreislaufs als auch die Rücklauftemperatur des aus diesem Wärmetauscher austretenden Kühlfluids im Betriebszustand der NMR-Apparatur mindestens 5 K tiefer als die Betriebstemperatur der ersten Kühlstufe des Kryokühlers ist.

### Wirkungsweise der Erfindung und weitere Vorteile gegenüber dem Stand der Technik

Die vorliegende Erfindung schlägt also eine NMR-Apparatur vor, in welcher der Kühlkreislauf eines NMR-Kryoprobenkopfs Wärmeleistung aus dem Kryostaten einer supraleitenden Magnetanordnung aufnehmen und auf die zweite Kühlstufe eines Kryokühlers leiten kann. In einem Kryostaten mit einem Heliumbehälter zur Aufnahme und Kühlung eines supraleitenden Magnetspulensystems kann auf diese Weise die Helium-Abdampfrate aus dem Heliumbehälter stark reduziert werden, indem beispielsweise ein um den Heliumbehälter herum angeordneter Strahlungsschild über den Kühlkreislauf auf Temperaturen von typischerweise 10 K - 30 K gekühlt wird. Der Verzicht auf eine vollständige Unterdrückung der Heliumverdampfung ist vorteilhaft, weil die benötigte Kühlleistung nicht mehr auf einer Temperatur unterhalb der Siedetemperatur von Helium bereitgestellt werden muss. Dadurch kann ein günstigerer Kühler verwendet werden und es ist kein direkter mechanischer Kontakt zwischen Kühler und Kryostat nötig, im Gegensatz zu Anordnungen zur Helium-Verflüssigung, wo der Kühler auf dem Kryostaten angeordnet werden muss. Dadurch kann die Übertragung von Vibrationen auf die supraleitende Magnetanordnung vermindert werden.

Alternativ zu einem Strahlungsschild kann auch eine Magnetspulenanordnung gekühlt werden, welche sich direkt im Isolationsvakuum eines kryogenfreien Kryostaten befindet, sofern die supraleitende Sprungtemperatur des verwendeten Supraleiters über einer Temperatur von 10 K liegt. Dies ist beispielsweise bei supraleitenden Magnetspulensystemen mit Hochtemperatursupraleiter (HTS) oder Magnesium-Diborid (MgB2) der Fall.

Zusätzlich kann eine weitere Kältestufe des Kryostaten vom Kühlkreislauf gekühlt werden, bei welcher die Rücklauftemperatur des Kühlfluids über der Betriebstemperatur der ersten Stufe des Kryokühlers liegt.

### Bevorzugte Ausführungsformen der Erfindung

Ganz besonders bevorzugt sind Ausführungsformen der Erfindung, bei denen der Kühlkreislauf wärmeisolierte Kühlleitungen außerhalb des wärmeisolierten Gehäuses aufweist und der Vakuumbehälter des Kryostaten gegenüber einem Isolationsvakuum der wärmeisolierten Kühlleitungen des Kühlkreislaufs vakuumdicht verschlossen ist. Dadurch wird verhindert, dass das Isolationsvakuum des Kryostaten bei einem Vakuumbruch im Kühlkreislauf gebrochen wird.

Bevorzugt ist auch eine Klasse von Ausführungsformen der erfindungsgemäßen NMR-Apparatur, bei denen gekühlte Probenkopfkomponenten in einem eigenen wärmeisolierten Behälter innerhalb des Raumtemperaturzugangs des Kryostaten angeordnet sind, und bei denen wärmeisolierte Kühlleitungen zwischen dem wärmeisolierten Gehäuse des Kryokühlers und den gekühlten Probenkopfkomponenten oder dem Wärmetauscher auf den gekühlten Probenkopfkomponenten sowie dem Wärmetauscher im Kryostatvakuum geführt sind. Die Anordnung von zu kühlenden Probenkopf- und Kryostatkomponenten in apparativ getrennten Isolationsvakua erhöht die Modularität der NMR-Apparatur, so dass beispielsweise ein Austausch des NMR-Probenkopfs möglich wird, ohne dass das Isolationsvakuum des Kryostaten dafür gebrochen werden muss.

Eine vorteilhafte Weiterbildung dieser Klasse von Ausführungsformen ist dadurch gekennzeichnet, dass der Kühlkreislauf Kühlfluid von der zweiten Kühlstufe des Kryokühlers nacheinander an den Wärmetauscher im Kryostatvakuum und dann an eine gekühlte Probenkopfkomponente oder an einen Wärmetauscher auf einer gekühlten Probenkopfkomponenten führt.

Alternativ dazu wird in einer weiteren Klasse von Ausführungsformen das Kühlfluid des Kühlkreislaufs von der zweiten Kühlstufe des Kryokühlers nacheinander an eine gekühlte Probenkopfkomponente oder an den Wärmetauscher auf einer gekühlten Probenkopfkomponente und dann an den Wärmetauscher im Kryostatvakuum geführt. Diese beiden alternativen Ausführungsformen erlauben es, die tiefste vom Kühlkreislauf bereitgestellte Temperatur entweder für eine optimale Kühlung der gekühlten Probenkopfkomponenten oder aber für eine optimale Kühlung einer Kältestufe des Kryostaten zu nutzen.

Andere vorteilhafte Weiterbildungen zeichnen sich dadurch aus, dass der Kühlkreislauf Kühlfluid von der zweiten Kühlstufe des Kryokühlers parallel sowohl an eine gekühlte Probenkopfkomponente oder an einen Wärmetauscher auf einer gekühlten Probenkopfkomponente als auch an einen Wärmetauscher im Kryostatvakuum führt. Mit diesen Ausführungsformen wird sichergestellt, dass die tiefste vom Kühlkreislauf bereitgestellte Temperatur gleichermaßen sowohl zur Kühlung der gekühlten Probenkopfkomponenten als auch zur Kühlung einer Kältestufe des Kryostaten genutzt werden kann.

Besonders bevorzugt sind auch Ausführungsformen der Erfindung, bei denen gekühlte Probenkopfkomponenten mindestens zum Teil in einem Bereich zwischen der Kaltbohrung des supraleitenden Magnetspulensystems und dem Raumtemperaturzugang des Kryostaten in die Kaltbohrung radial innerhalb der Kaltbohrung, aber außerhalb des Raumtemperaturzugangs des Kryostaten angeordnet und wärmeleitend mit dem an den Kühlkreislauf angeschlossenen Wärmetauscher im Kryostatvakuum verbunden sind. Aus dem Einbau der gekühlten Probenkopfkomponenten ins Isolationsvakuum des Kryostaten der supraleitenden Magnetanordnung resultiert ein Platzgewinn im Bereich zwischen der Kaltbohrung des supraleitenden Magnetspulensystems und dem Probenraum innerhalb des NMR-Probenkopfs. Außerdem werden die Anordnung und der Kühlkreislauf dadurch apparativ vereinfacht, was auch zu einer Reduktion von Kühlleistungsverlusten im Kühlkreislauf führt. Eine solche Ausführungsform ist besonders dann vorteilhaft, wenn die NMR-Apparatur dauerhaft mit demselben NMR-Probenkopf betrieben wird.

Bei bevorzugten Weiterbildungen dieser Ausführungsformen ist der an den Kühlkreislauf angeschlossener Wärmetauscher im Kryostatvakuum wärmeleitend sowohl mit gekühlten NMR-Probenkopfkomponenten als auch mit einer Kältestufe des Kryostaten verbunden. Dadurch wird eine optimale Kühlung sowohl der gekühlten Probenkopfkomponenten als auch der zu kühlenden Kältestufe des Kryostaten ermöglicht.

Vorteilhaft sind auch Ausführungsformen der Erfindung, die dadurch gekennzeichnet sind, dass mindestens zwei an den Kühlkreislauf angeschlossene Wärmetauscher im Kryostatvakuum vorhanden sind, wobei die Rücklauftemperatur des von dem an den Kühlkreislauf angeschlossenen Wärmetauscher im Kryostatvakuum kommenden Kühlfluids des Kühlkreislaufs höher ist als die Betriebstemperatur der ersten Stufe des Kryokühlers. Bei diesen Anordnungen kann nicht nur die Kühlleistung der zweiten sondern auch der ersten (wärmeren) Kühlstufe des Kryokühlers zur Kühlung einer Kältestufe des Kryostaten genutzt werden. Insbesondere kann beispielsweise Stickstoffgas aus einem Stickstoffbehälter des Kryostaten verflüssigt werden, oder es kann ein Strahlungsschild auf Temperaturen zwischen 35 K und 80 K gekühlt werden.

Bei einer weiteren bevorzugten Ausführungsform ist der an den Kühlkreislauf angeschlossener Wärmetauscher im Kryostatvakuum oder in einem Aufhängerohr des Heliumbehälters des Kryostaten angeordnet und wärmeleitend mit einer Kältestufe des Kryostaten verbunden, welche einen Strahlungsschild oder einen Kryogenbehälter umfasst. Diese Ausführungsformen sind insbesondere für Magnetanordnungen mit einem supraleitenden Magnetspulensystem aus Tieftemperatur-Supraleiter vorteilhaft, bei welchen der Kryostat typischerweise einen Heliumbehälter zur Aufnahme des supraleitenden Magnetspulensystems umfasst, welcher von einem Strahlungsschild umgeben ist, den wiederum ein Stickstoffbehälter umschließt (Helium-Stickstoff-Badkryostat). In einer solchen Anordnung kann ein Wärmetauscher im Kryostatvakuum angeordnet und thermisch mit dem Strahlungsschild kontaktiert werden. Wenn der Wärmetauscher in jenem Abschnitt des Kühlkreislaufs eines NMR-Kryoprobenkopfs an den Kühlkreislauf angeschlossen ist, in welchem das Kühlfluid Wärme an die zweite Kühlstufe des Kryokühlers abgibt, kann der Strahlungsschild typischerweise auf Temperaturen von 10 K - 30 K gekühlt werden. Dadurch kann die Heliumabdampfrate gegenüber einem Kryostaten ohne diese Anbindung an den Kühlkreislauf deutlich reduziert werden.

In einem Helium-Stickstoff-Badkryostaten wird vorzugsweise in einem Aufhängerohr des Heliumbehälters, welches auch als Auslass für verdampftes Heliumgas dient, eine thermische Kontaktierung zum Strahlungsschild angebracht, um den Heliumgasstrom zur Kühlung des Strahlungsschildes zu nutzen. An dieser Stelle kann im Aufhängerohr des Heliumbehälters ein an den Kühlkreislauf des Kryoprobenkopfs angeschlossener Wärmetauscher angebracht werden, welcher den Strahlungsschild kühlen kann. Der Vorteil dieser Anordnung des Wärmetauschers gegenüber einer Anordnung im Kryostatvakuum ist, dass damit beispielsweise ein bestehender Helium-Stickstoff-Badkryostat nachgerüstet werden kann. In einer weiteren Variante dieser Ausführungsformen wird ein an den Kühlkreislauf des Kryoprobenkopfs angeschlossener Wärmetauscher im Kryostatvakuum auf dem Stickstoffbehälter angebracht, so dass dieser Behälter auf eine Temperatur unterhalb 77 K gekühlt wird, wodurch die Verdampfung von Stickstoff aus dem Behälter verhindert wird.

Eine Klasse von vorteilhaften Ausführungsformen der Erfindung zeichnet sich dadurch aus, dass das supraleitende Magnetspulensystem unmittelbar im Isolationsvakuum des Kryostaten angeordnet ist, und dass ein an den Kühlkreislauf angeschlossener Wärmetauscher im Kryostatvakuum mit dem supraleitenden Magnetspulensystem wärmeleitend verbunden ist, wobei das supraleitende Magnetspulensystem die Supraleitermaterialien MgB2 oder HTS (BSCCO, ReBCO) aufweist. Bei diesen Anordnungen wirkt sich die am Wärmetauscher im Kryostatvakuum erreichbare Temperatur von weniger als 30 K besonders vorteilhaft auf die supraleitende Magnetanordnung aus, weil die genannten Supraleitermaterialien bei diesen Temperaturen bereits supraleitend werden können, so dass auf eine aufwändigere Kühlung mit einem Flüssigheliumbad verzichtet werden kann.

Bei einer dazu alternativen Klasse von Ausführungsformen sind gekühlte Probenkopfkomponenten im eigenen wärmeisolierten Behälter innerhalb des Raumtemperaturzugangs des Kryostaten angeordnet, umfasst der Kryostat den Heliumbehälter zur Aufnahme des supraleitenden Magnetspulensystems und den ersten Strahlungsschild und den Stickstoffbehälter oder den zweiten Strahlungsschild, und ist der Kühlkreislauf durch den Vakuumbehälter des Kryostaten hindurch zu mindestens zwei Wärmetauschern im Kryostatvakuum geführt, wobei der erste an den Kühlkreislauf angeschlossene Wärmetauscher wärmeleitend mit dem ersten Strahlungsschild verbunden ist und die Rücklauftemperatur des von diesem Wärmetauscher kommenden Kühlfluids tiefer als die Betriebstemperatur der ersten Stufe des Kryokühlers ist, und wobei der zweite an den Kühlkreislauf angeschlossene Wärmetauscher wärmeleitend mit dem Stickstoffbehälter oder dem zweiten Strahlungsschild verbunden ist und die Rücklauftemperatur des von diesem Wärmetauscher kommenden Kühlfluids höher als die Betriebstemperatur der ersten Stufe des Kryokühlers ist. Diese Ausführungsformen bauen in vorteilhafter Weise auf einem handelsüblichen NMR-Kryoprobenkopf und dessen Kühlkreislauf auf. Darüber hinaus wird eine gebräuchliche Auslegung des Kryostaten einer supraleitenden Magnetanordnung insbesondere zur Kühlung von supraleitenden Magnetspulensystemen aus Tieftemperatursupraleitern verwendet. Besonders vorteilhaft ist, dass überschüssige Kühlleistung von beiden Kühlstufen des Kryokühlers des Kühlkreislaufs des NMR-Kryoprobenkopfs zur Kryostatkühlung genutzt wird. Eine weitere Klasse von wiederum alternativen Ausführungsform ist dadurch gekennzeichnet, dass gekühlte Probenkopfkomponenten im eigenen wärmeisolierten Behälter innerhalb des Raumtemperaturzugangs des Kryostaten angeordnet sind, dass der Kryostat den Heliumbehälter zur Aufnahme des supraleitenden Magnetspulensystems und den Strahlungsschild und den Stickstoffbehälter umfasst, dass der Kühlkreislauf durch den Vakuumbehälter des Kryostaten hindurch zum Wärmetauscher im Kryostatvakuum geführt ist, welcher wärmeleitend mit dem Strahlungsschild verbunden ist, wobei die Rücklauftemperatur des von diesem Wärmetauscher kommenden Kühlfluids tiefer als die Betriebstemperatur der ersten Stufe des Kryokühlers ist, und dass sich ein zweiter an den Kühlkreislauf angeschlossener Wärmetauscher im Stickstoffbehälter oder in einem mit dem Stickstoffbehälter kommunizierenden Behälter befindet, wobei die Rücklauftemperatur des von diesem Wärmetauscher kommenden Kühlfluids höher als die Betriebstemperatur der ersten Stufe des Kryokühlers ist. Diese Ausführungsformen bauen in vorteilhafter Weise auf einem handelsüblichen NMR-Kryoprobenkopf und dessen Kühlkreislauf auf. Darüber hinaus wird eine gebräuchliche Auslegung des Kryostaten einer supraleitenden Magnetanordnung insbesondere zur Kühlung von supraleitenden Magnetspulensystemen aus Tieftemperatursupraleitern verwendet. Besonders vorteilhaft ist, dass überschüssige Kühlleistung von beiden Kühlstufen des Kryokühlers des Kühlkreislaufs des NMR-Kryoprobenkopfs zur Kryostatkühlung genutzt wird. Die Anbringung eines zweiten an den Kühlkreislauf angeschlossenen Wärmetauschers im Stickstoffbehälter des Kryostaten oder in einem mit dem Stickstoffbehälter kommunizierenden Behälter stellt gegenüber einer Anbringung im Kryostatvakuum eine vorteilhafte apparative Vereinfachung dar. Außerdem ist diese Anordnung besonders zur Nachrüstung von bestehenden Kryostaten geeignet.

Schließlich ist es auch von erheblichem Vorteil, wenn die gekühlten Probenkopfkomponenten einen HF-Resonator und/oder einen Vorverstärker umfassen. Bei diesen beiden Komponenten eines NMR-Probenkopfes wirkt sich die Kühlung besonders vorteilhaft auf die Signalqualität aus.

### Detaillierte Beschreibung der Erfindung und Zeichnung

Die Erfindung ist in den Figuren der Zeichnung dargestellt. Es zeigen:

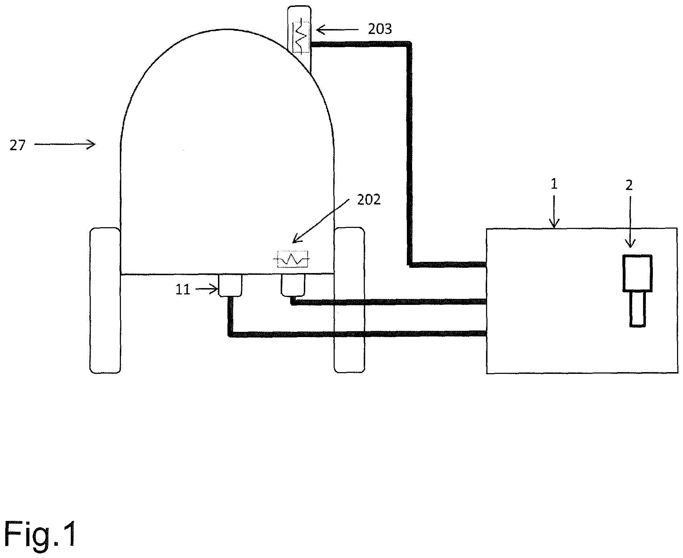

- Fig. 1: eine schematische Darstellung einer NMR-Apparatur, mit supraleitender Magnetanordnung 27, NMR-Probenkopf 11, wärmeisoliertem Gehäuse 1 zur Aufnahme eines Kryokühlers 2, sowie drei Schnittstellen zur Kühlungsankopplung, welche exemplarisch durch einen Wärmetauscher 202 im Kryostatvakuum, einen Wärmetauscher 203 in einem mit einem Stickstoffbehälter 18 kommunizierenden Behälter 204, sowie der Anbindung zum NMR-Probenkopf 11 angedeutet sind;

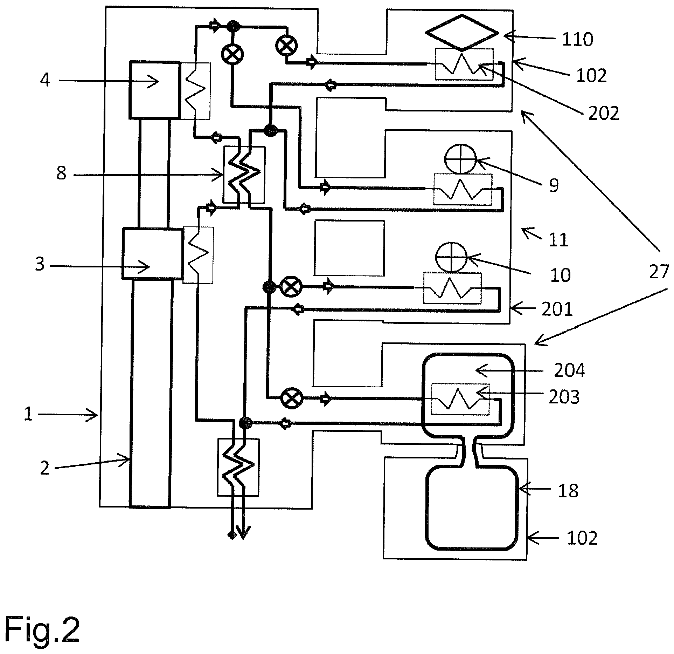

- Fig. 2: eine schematische Darstellung einer Ausführungsform eines Kühlkreislaufes einer NMR-Apparatur, bei der der Kühlfluidstrom auf zwei Temperaturniveaus jeweils geteilt wird, wobei auf dem tieferen Temperaturniveau ein Strahlungsschild 110 einer supraleitenden Magnetanordnung 27 und eine gekühlte Probenkopfkomponente 9 gekühlt wird, und auf dem höheren Temperaturniveau eine gekühlte Probenkopfkomponente 10 gekühlt wird und zudem Stickstoff in einem mit dem Stickstoffbehälter 18 einer supraleitenden Magnetanordnung 27 kommunizierenden Behälter 204 verflüssigt wird;

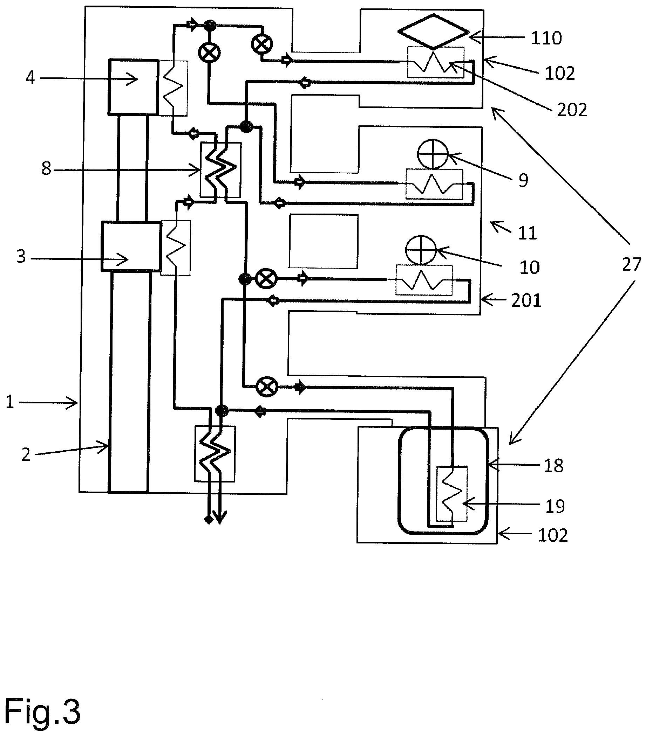

- Fig. 3: eine schematische Darstellung einer Ausführungsform eines Kühlkreislaufes einer NMR-Apparatur, bei der der Kühlfluidstrom auf zwei Temperaturniveaus jeweils geteilt wird, wobei auf dem tieferen Temperaturniveau ein Strahlungsschild 110 einer supraleitenden Magnetanordnung 27 und eine gekühlte Probenkopfkomponente 9 gekühlt wird, und auf dem höheren Temperaturniveau eine gekühlte Probenkopfkomponente 10 gekühlt wird und zusätzlich Stickstoff in einem Stickstoffbehälter 18 einer supraleitenden Magnetanordnung 27 verflüssigt wird, wobei ein Wärmetauscher 19 im Stickstoffbehälter 18 lokalisiert ist;

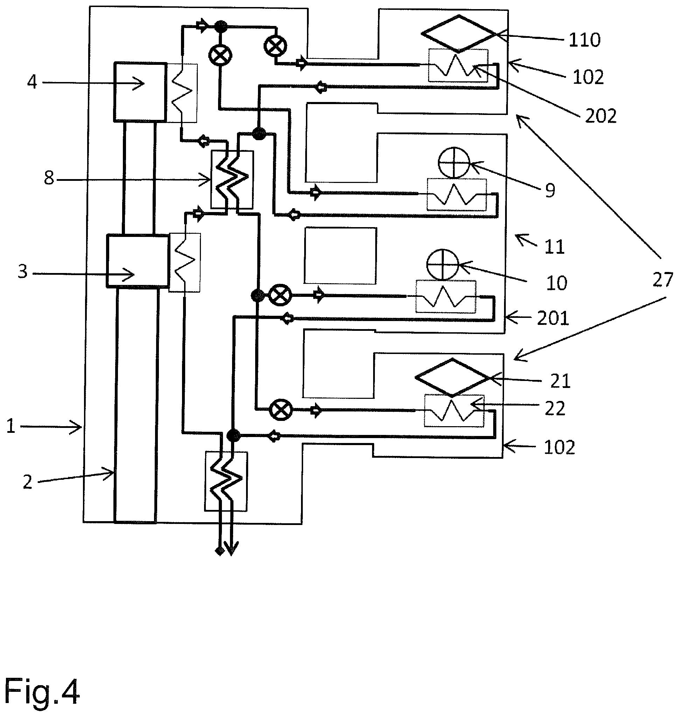

- Fig. 4: eine schematische Darstellung einer Ausführungsform eines Kühlkreislaufes einer NMR-Apparatur, bei der der Kühlfluidstrom auf zwei Temperaturniveaus jeweils geteilt wird, wobei auf dem tieferen Temperaturniveau ein Strahlungsschild 110 einer supraleitenden Magnetanordnung 27 und eine gekühlte Probenkopfkomponente 9 gekühlt wird, und auf dem höheren Temperaturniveau eine gekühlte Probenkopfkomponente 10 und zudem ein zweiter Strahlungsschild 21 einer supraleitenden Magnetanordnung 27 gekühlt wird;

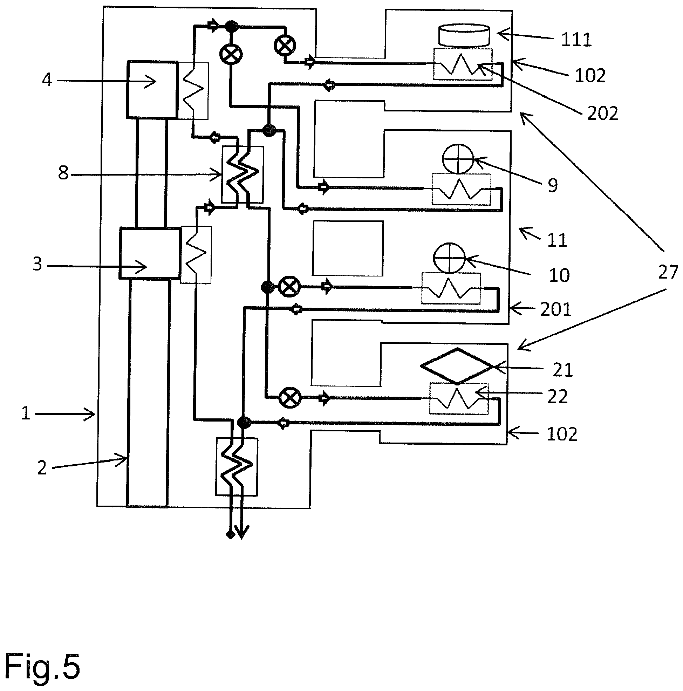

- Fig. 5: eine schematische Darstellung einer Ausführungsform eines Kühlkreislaufes einer NMR-Apparatur, bei der der Kühlfluidstrom auf zwei Temperaturniveaus jeweils geteilt wird, wobei auf dem tieferen Temperaturniveau ein supraleitendes Magnetspulensystem 111 einer supraleitenden Magnetanordnung 27 und eine gekühlte Probenkopfkomponente 9 gekühlt wird, und auf dem höheren Temperaturniveau eine gekühlte Probenkopfkomponente 10 und zudem ein zweiter Strahlungsschild 21 einer supraleitenden Magnetanordnung 27 gekühlt wird;

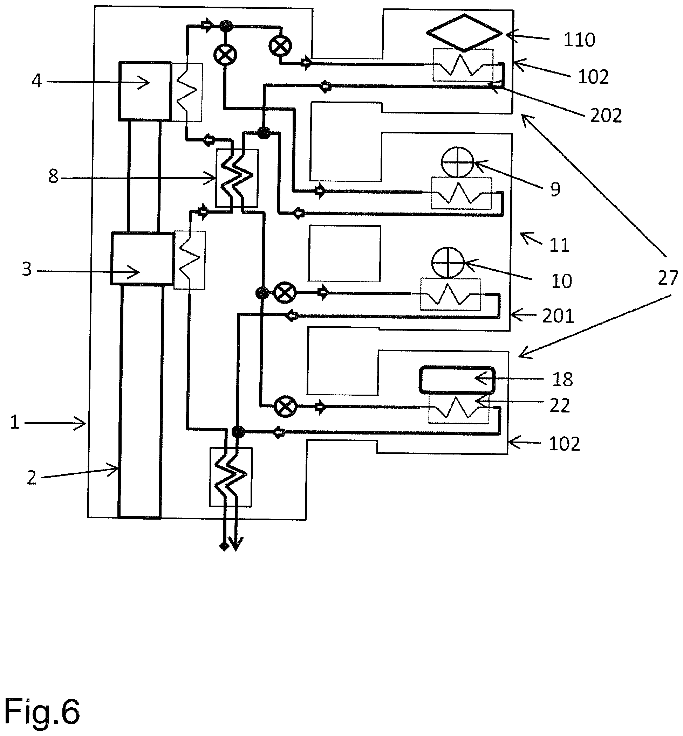

- Fig. 6: eine schematische Darstellung einer Ausführungsform eines Kühlkreislaufes einer NMR-Apparatur, bei der der Kühlfluidstrom auf zwei Temperaturniveaus jeweils geteilt wird, wobei auf dem tieferen Temperaturniveau ein Strahlungsschild 110 einer supraleitenden Magnetanordnung 27 und eine gekühlte Probenkopfkomponente 9 gekühlt wird, und auf dem höheren Temperaturniveau eine gekühlte Probenkopfkomponente 10 und zudem ein Wärmetauscher 22 gekühlt wird, wobei der Wärmetauscher 22 derart in thermischem Kontakt mit dem Stickstoffbehälter 18 steht, dass in diesem Stickstoff verflüssigt wird;

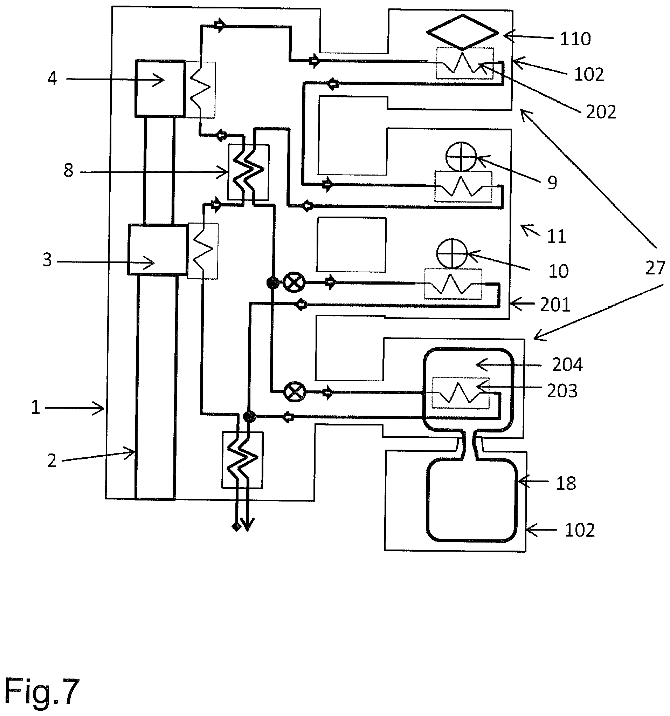

- Fig. 7: eine schematische Darstellung einer Ausführungsform eines Kühlkreislaufes einer NMR-Apparatur, bei der der Kühlfluidstrom nur auf dem höheren Temperaturniveau geteilt wird, und die Komponenten auf dem tieferen Temperaturniveau vom Kühlfluidstrom nacheinander (seriell) durchlaufen werden, wobei auf dem tieferen Temperaturniveau zuerst ein Strahlungsschild 110 einer supraleitenden Magnetanordnung 27 und dann eine gekühlte Probenkopfkomponente 9 gekühlt wird, und wobei auf dem höheren Temperaturniveau eine gekühlte Probenkopfkomponente 10 gekühlt wird und zudem Stickstoff in einem mit dem Stickstoffbehälter 18 einer supraleitenden Magnetanordnung 27 kommunizierenden Behälter 204 verflüssigt wird;

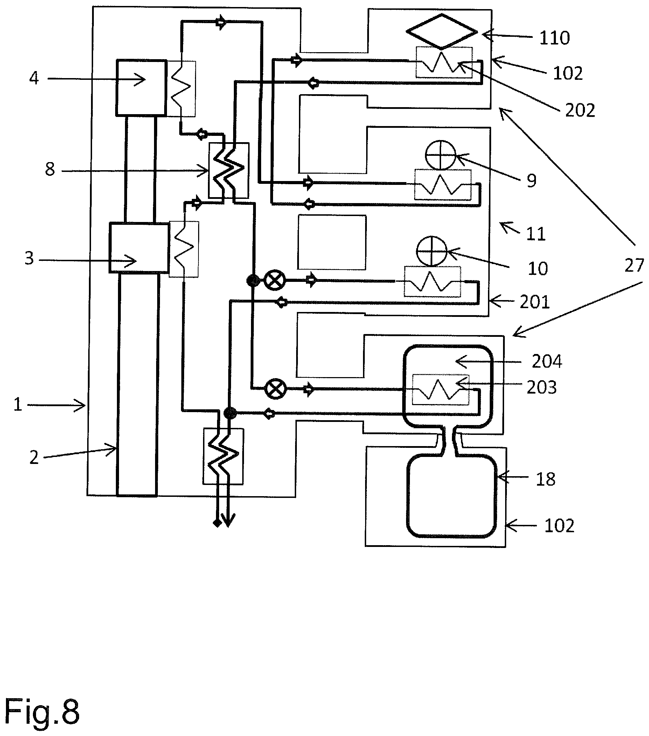

- Fig. 8: eine schematische Darstellung einer Ausführungsform eines Kühlkreislaufes einer NMR-Apparatur, bei der der Kühlfluidstrom nur auf dem höheren Temperaturniveau geteilt wird, und die Komponenten auf dem tieferen Temperaturniveau vom Kühlfluidstrom nacheinander (seriell) durchlaufen werden, wobei auf dem tieferen Temperaturniveau zuerst eine gekühlte Probenkopfkomponente 9 und dann ein Strahlungsschild 110 einer supraleitenden Magnetanordnung 27 durchlaufen werden, und wobei auf dem höheren Temperaturniveau eine gekühlte Probenkopfkomponente 10 gekühlt wird und zudem Stickstoff in einem mit dem Stickstoffbehälter 18 einer supraleitenden Magnetanordnung 27 kommunizierenden Behälter 204 verflüssigt wird;

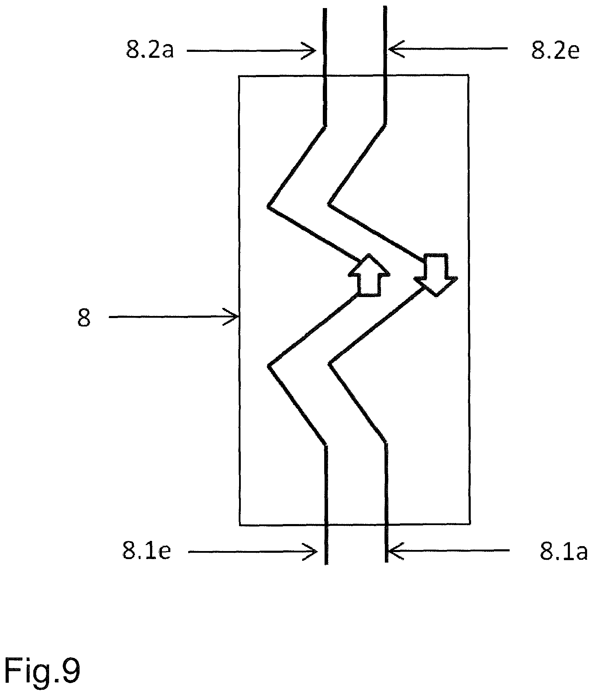

- Fig. 9: einen Gegenstromwärmetauscher 8 mit den Eingängen 8.1e und 8.2e und den Ausgängen 8.1a und 8.2a;

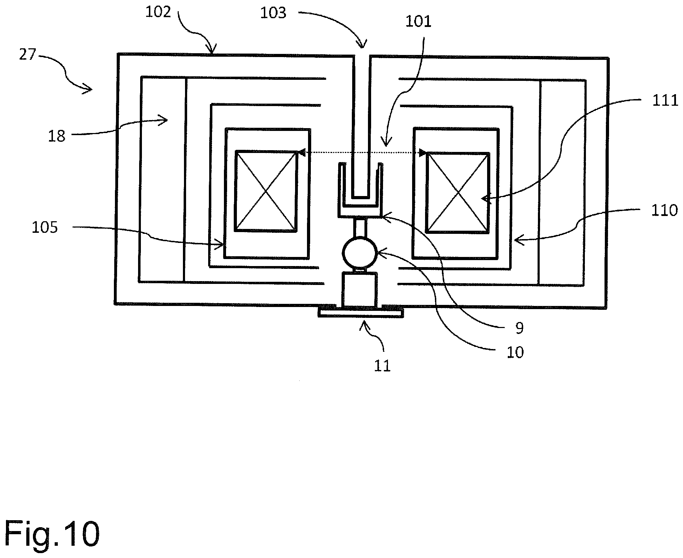

- Fig. 10: eine schematische Darstellung einer Ausführungsform einer supraleitenden Magnetanordnung 27 und eines NMR-Probenkopfes 11 einer NMR-Apparatur, bei der die gekühlten Probenkopfkomponenten 9, 10 des NMR-Probenkopfes 11 im Kryostatvakuum angeordnet sind und dieser den Vakuumbehälter 102 des Kryostaten vakuumdicht abschließt, und bei der die Raumtemperaturbohrung 103 des Kryostaten axial nur bis zur Position einer gekühlten Probenkopfkomponente 9 eines NMR-Probenkopfes 11 ausgeführt ist;

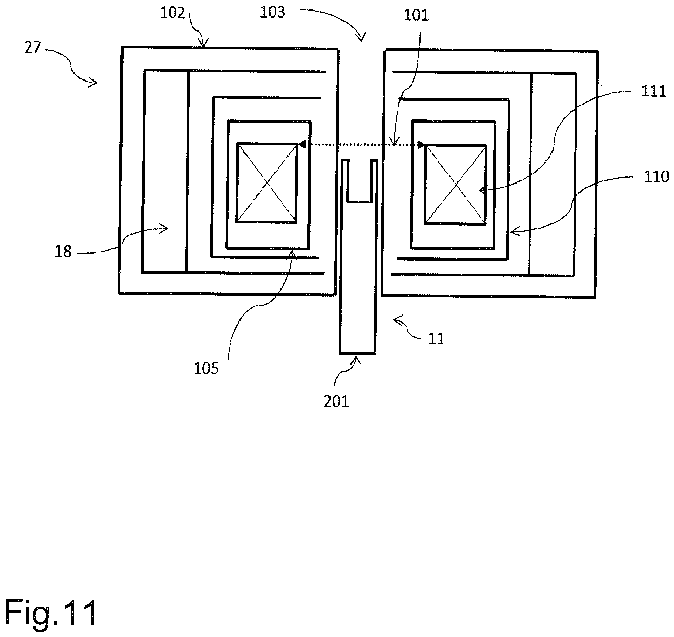

- Fig. 11: eine schematische Darstellung einer Ausführungsform einer supraleitenden Magnetanordnung 27 und eines NMR-Probenkopfes 11 einer NMR-Apparatur, bei der die Raumtemperaturbohrung 103 durchgehend ausgeführt ist, und bei der ein wärmeisolierter Behälter 201 des NMR-Probenkopfes 11 innerhalb der Raumtemperaturbohrung 103 angeordnet ist, und wobei die supraleitende Magnetanordnung 27 einen Stickstoffbehälter 18 umfasst;

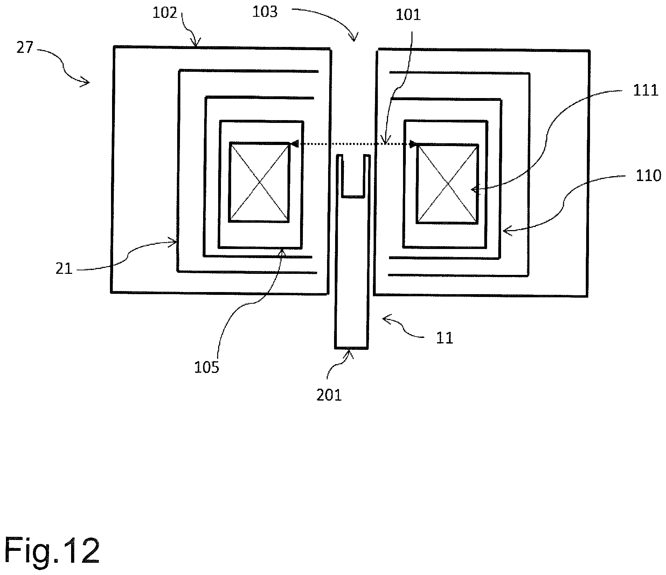

- Fig. 12: eine schematische Darstellung einer Ausführungsform einer supraleitenden Magnetanordnung 27 und eines NMR-Probenkopfes 11 einer NMR-Apparatur, bei der die Raumtemperaturbohrung 103 durchgehend ausgeführt ist, und bei der der wärmeisolierte Behälter des NMR-Probenkopfes 11 innerhalb der Raumtemperaturbohrung 103 angeordnet ist, und wobei die supraleitende Magnetanordnung 27 einen zweiten Strahlungsschild 21 umfasst; und

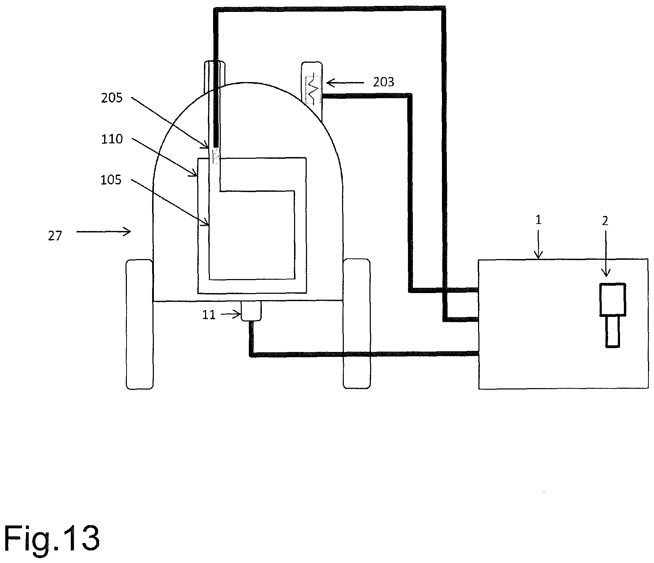

- Fig. 13: eine schematische Darstellung einer Ausführungsform einer supraleitenden Magnetanordnung 27, eines NMR-Probenkopfes 11 und eines Kühlkreislaufes einer NMR-Apparatur, bei der der Kühlfluidstrom auf zwei Temperaturniveaus zur supraleitenden Magnetanordnung 27 geleitet wird, wobei auf dem tieferen Temperaturniveau ein Strahlungsschild 110 der supraleitenden Magnetanordnung 27 gekühlt wird, und auf dem höheren Temperaturniveau verdampfter Stickstoff aus der supraleitenden Magnetanordnung 27 verflüssigt wird, und wobei die Kühlung des Strahlungsschildes 110 durch einen in einem Aufhängerohr des Heliumbehälters 105 der supraleitenden Magnetanordnung 27 platzierten Wärmetauscher 205 erfolgt.

Die Erfindung wird im Folgenden anhand von Ausführungsbeispielen näher erläutert:
Figur 2 zeigt schematisch die Topologie des Kühlfluidstromes in einer beispielhaften Ausführung. In den folgenden Figuren 3 bis 8 wird dieses Grunddesign für weitere Anwendungsfälle variiert.

Der Aufbau umfasst vier funktionellen Einheiten, nämlich den Kryokühler 2, die zu kühlenden Komponenten, den Kompressor, sowie die Fluidleitungen mit den Wärmetauschern. Links auf dem Bild ist der Kryokühler 2 mit seiner ersten und zweiten Kühlstufe 3, 4 zu sehen. Auf der rechten Seite finden wir beispielhaft die vier zu kühlenden Komponenten 110, 9, 10 und 204, wobei jeweils zwei ungefähr auf der Temperatur der ersten und der zweiten Kühlstufe 3, 4 liegen. Die Kühlung wird durch ein umlaufendes Kühlfluid vermittelt, das die jeweiligen Kühlstufen 3, 4 thermisch an die räumlich entfernt liegenden zu kühlenden Komponenten 110, 9, 10, 204 koppelt, wobei diese Kopplung durch Wärmetauscher geschieht, die vom Kühlfluid durchflossen werden, oder durch direkten Kontakt der Komponenten mit dem Kühlfluid. Das Fluid wird durch einen bei Raumtemperatur befindlichen Kompressor umgetrieben, der z.B. auch der Kompressor des Kryokühlers 2 sein darf, von dem ein kleiner Teilstrom abgezweigt wird. Sehr wichtig sind auch die beiden Gegenstromwärmetauscher. Diese ermöglichen den Betrieb der einzelnen Komponenten auf drei verschiedenen Temperaturniveaus, nämlich des Kompressors bei Raumtemperatur, der ersten Kühlstufe 3 und der beiden wärmeren zu kühlenden Komponenten 10, 204 auf einer Zwischentemperatur, sowie der zweiten Kühlstufe 4 und der beiden kälteren zu kühlenden Komponenten 110, 9 auf der niedrigsten Temperatur.

Folgt man dem Kühlfluid vom Kompressor kommend, so durchläuft es zuerst einen Gegenstromwärmetauscher, der es auf eine Temperatur oberhalb aber in der Größenordnung der ersten Kühlstufe 3 bringt. An dieser wird das Kühlfluid auf deren Temperatur heruntergekühlt, bevor es über den Gegenstromwärmetauscher 8 auf eine Temperatur oberhalb aber in der Größenordnung der zweiten Kühlstufe 4 gelangt, und dann an dieser auf deren Temperatur abgekühlt wird. Damit ist das Kühlfluid am kältesten Punkt des Kühlkreislaufs angelangt und durchläuft im Folgenden jenen Ast des Kühlkreislaufs, in welchem es Wärme an den zu kühlenden Komponenten und an den Gegenstromwärmetauschern aufnimmt, bis es am Ende wieder bei Raumtemperatur angelangt ist und in die Niederdruckseite des Kompressors zurückgeleitet wird. Dieser Ast des Kühlkreislaufs unterscheidet sich in verschiedenen Ausführungsformen dadurch, welche Komponenten gekühlt werden oder wie das Kühlfluid topologisch geführt wird. Zwei auf derselben Temperaturstufe liegende Komponenten können hierbei seriell oder parallel geschaltet sein.

Bei der in Figur 2 gezeigten Variante werden neben den in allen Varianten vorkommenden gekühlten Probenkopfkomponenten 9, 10 noch die Kühlung eines ersten Strahlungsschildes 110 auf dem tieferen der beiden Temperaturniveaus, sowie die Kühlung eines Wärmetauschers 203 zur Verflüssigung von Stickstoff in einem mit dem Stickstoffbehälter 18 kommunizierenden Behälter 204 gezeigt. Die Kühlung eines ersten Strahlungsschildes 110 durch den Kühlfluidstrom auf dem kälteren der beiden Temperaturniveaus erlaubt es, die Temperatur des Strahlungsschildes im Vergleich zu herkömmlichen Kryostatanordnungen abzusenken, was in einer reduzierten Heliumabdampfrate der supraleitenden Magnetanordnung 27 resultiert, und damit zu längeren Füllintervallen für Flüssighelium führt.

Vakuumtechnisch gesehen kann der Gesamtaufbau in drei jeweils evakuierte Volumina unterteilt werden, die vom wärmeisolierten Gehäuse 1, dem Vakuumbehälter 102 des Kryostaten, sowie dem wärmeisolierten Behälter 201 des NMR-Probenkopfes 11 eingeschlossen werden. In den Figuren werden diese Vakua durchgehend vereinfacht als kommunizierend gezeigt. Sie können aber auch mit baulichen Maßnahmen wie Ventilen, Durchführungen, und/ oder Fluidkupplungen ausgeführt sein, die eine vakuumtechnische Funktionstrennung der Volumina ermöglichen. Ebenso können auch die schlauchartigen Isolationsvakua der Verbindungsleitungen zwischen wärmeisoliertem Gehäuse 1 und Vakuumbehälter 102 des Kryostaten und/ oder dem wärmeisolierten Behälter 201 des NMR-Probenkopfes 11 als vakuumtechnisch separierbare Volumina ausgeführt werden, z.B. mittels Ventilen, Durchführungen oder Fluidkopplungen.

In der Figur 2 wurden der erste Strahlungsschild 110 und die gekühlte Probenkopfkomponente 9 vereinfacht mit je einem Wärmetauscher gekoppelt. Diese beiden Wärmetauscher liegen ungefähr auf demselben Temperaturniveau. Im Falle eines integrierten Designs von supraleitender Magnetanordnung 27 und NMR-Probenkopf 11, wie z.B. in Fig. 10 gezeigt, können der erste Strahlungsschild 110 und die gekühlte Probenkopfkomponente 9 auch zusammen an einen einzigen Wärmetauscher 102 gekoppelt werden. Der zweite Wärmetauscher entfällt dann.

Figur 3 zeigt eine Abwandlung von Figur 2, wobei hier anstelle der Stickstoffverflüssigung in einem separaten, mit dem Stickstoffbehälter 18 kommunizierenden Behälter 204 der Stickstoff direkt im Stickstoffbehälter 18 verflüssigt wird.

Figur 4 zeigt eine Abwandlung von Figur 2, wobei hier anstelle des Stickstoffbehälters 18 der supraleitenden Magnetanordnung 27 ein zweiter Strahlungsschild 21 angeordnet ist.

Figur 5 zeigt eine Abwandlung von Figur 2, wobei hier ein supraleitendes Magnetspulensystem 111 verwendet wird, dessen Betriebstemperatur oberhalb der Betriebstemperatur der zweiten Stufe 4 des Kryokühlers 2 liegt. In diesem Fall kann das Heliumbad und der Heliumbehälter 105 komplett entfallen, und der Magnet wird direkt durch das Kühlfluid gekühlt, z.B. wärmeleitungsgekühlt über einen Wärmetauscher. Der erste Strahlungsschild 110 entfällt in diesem Fall, der zweite Strahlungsschild 21 ist wie in Figur 4 ebenfalls vom Kühlfluidstrom gekühlt. Diese Variante ist vor allem für Anwendungen mit Hochtemperatur- oder auch MgB2-Supraleitern interessant.

Figur 6 zeigt eine Abwandlung von Figur 3, wobei der Wärmetauscher 22 zur Bereitstellung der Kühlleistung zur Stickstoffverflüssigung nicht im Stickstoffbehälter 18, sondern im angrenzenden Vakuumbereich untergebracht ist, und die Kühlleistung durch Wärmeleitung durch die den Vakuumraum begrenzende Wand erfolgt.

Figur 7 zeigt eine Abwandlung von Figur 2, wobei das Kühlfluid im kälteren Teil nicht parallel durch die beiden Arme läuft, sondern seriell (nacheinander). Durch diese Anordnung kann eine Temperaturstaffelung der zu kühlenden Komponenten in diesem Teil des Kühlkreislaufs erreicht werden, was von Vorteil ist, wenn z.B. der eine Arm sehr viel weniger Wärme einträgt als der andere, und die Performance des Systems an dieser Stelle stärker von einer stabilen und tiefen Temperatur profitiert.

Figur 8 zeigt eine Abwandlung von Figur 7, wobei die seriell verschalteten zu kühlenden Komponenten vom Kühlfluid in umgekehrter Reihenfolge durchlaufen werden.

Figur 10 zeigt eine schematische Darstellung einer Ausführungsform einer supraleitenden Magnetanordnung 27 und eines NMR-Probenkopfes 11 einer NMR-Apparatur, bei der die gekühlten Probenkopfkomponenten 9, 10 des NMR-Probenkopfes 11 im Kryostatvakuum angeordnet sind und dieser den Vakuumbehälter 102 des Kryostaten vakuumdicht abschließt, und bei der die Raumtemperaturbohrung 103 des Kryostaten axial nur bis zur Position einer gekühlten Probenkopfkomponente 9 eines NMR-Probenkopfes 11 ausgeführt ist. Das supraleitende Magnetspulensystem 111 ist dabei in einem Heliumbehälter 105 platziert, wo es auf seiner Betriebstemperatur, typischerweise bei flüssigem Helium, gehalten wird.

Der Heliumbehälter 105 ist von einem ersten Strahlungsschild 110 umgeben, welcher den größten Teil der vom Stickstoffbehälter 18 her einfallenden Strahlungswärme vom Heliumbehälter 105 fernhält, und dadurch zur Senkung der Heliumverbrauchswerte führt. Je tiefer die Temperatur dieses ersten Strahlungsschildes 110 ist, desto geringer ist die Abdampfrate des Heliums aus dem Heliumbehälter 105. Der erste Strahlungsschild 110 ist von einem Stickstoffbehälter 18 umgeben, der wiederum den größten Teil der einfallenden Wärme vom sich auf Raumtemperatur befindenden Vakuumbehälter 102 des Kryostaten vom ersten Strahlungsschild 110 fernhält.

Alle Zwischenräume zwischen Heliumbehälter 105, erstem Strahlungsschild 110, Stickstoffbehälter 18 und Vakuumbehälter 102 des Kryostaten sind evakuiert (Vakuum), um Wärmeeintrag durch Wärmeleitung und Konvektion zu unterbinden. Das supraleitende Magnetspulensystem 111 hat eine Kaltbohrung 101, in welche ein Raumtemperaturzugang 103 eingreift. Dieser dient dazu, die zu vermessende Probe in der Mitte der supraleitenden Magnetanordnung zu platzieren. Zwischen dieser zentralen Magnetfeldregion und dem supraleitenden Magnetspulensystem 111 ist eine gekühlte Probenkopfkomponente 9 platziert. Diese dient dazu, Radiofrequenzstrahlung auf die Probe einzustrahlen bzw. das zurückkommende Signal aus der Probe zu detektieren. Unterhalb der gekühlten Probenkopfkomponente 9 ist eine weitere gekühlte Probenkopfkomponente 10 platziert, welche dazu dient, das von der Probe kommende äußerst schwache Radiofrequenzsignal aufzubereiten, bevor es an andere Teile des NMR-Spektrometers weitergeleitet wird. Diese beiden Komponenten sind Teile des NMR-Probenkopfes 11, der hier zudem eine Begrenzungsfunktion des Isolationsvakuums der supraleitenden Magnetanordnung 27 hat.

Figur 11 zeigt eine schematische Darstellung einer Ausführungsform einer supraleitenden Magnetanordnung 27 und eines NMR-Probenkopfes 11 einer NMR-Apparatur, bei der der NMR-Probenkopf 11 mit den gekühlten Probenkopfkomponenten 9, 10 baulich getrennt von der supraleitenden Magnetanordnung 27 ausgeführt ist. Der Aufbau der supraleitenden Magnetanordnung 27 ist in dieser Ausführungsform mit einem durchgehenden Raumtemperaturzugang 103 ausgeführt. Der NMR-Probenkopf 11 hat einen wärmeisolierten Behälter 201 mit einem Isolationsvakuum zur Aufnahme der gekühlten Probenkopfkomponenten 9, 10. Die supraleitende Magnetanordnung 27 und der NMR-Probenkopf 11 sind dadurch vakuumtechnisch vollständig unabhängig voneinander.

Figur 12 zeigt eine Abwandlung von Figur 11, wobei hier anstelle des Stickstoffbehälters 18 der supraleitenden Magnetanordnung 27 ein zweiter Strahlungsschild 21 angeordnet ist.

Figur 13 schließlich zeigt eine Abwandlung von Figur 2, bei der der Kühlkreislauf durch ein Aufhängerohr des Heliumbehälters 105 der supraleitenden Magnetanordnung 27 an einen Wärmetauscher 205 im Aufhängerohr des Heliumbehälters geführt ist. Dieser Wärmetauscher 205 ist an der Stelle des Aufhängerohres platziert, die mit dem ersten Strahlungsschild 110 in engem thermischen Kontakt steht, so dass sich die Kühlleistung hier effizient einkoppeln lässt. Die Ausführung erlaubt eine "retrofit"-Installation in bereits existierende supraleitende Magnetanordnungen 27, da keine baulichen Veränderungen an diesen vorgenommen werden müssen.

### Bezugszeichenliste:

- 1: wärmeisoliertes Gehäuse
- 2: Kryokühler
- 3: erste Kühlstufe des Kryokühlers
- 4: zweite Kühlstufe des Kryokühlers
- 8: Gegenstromwärmetauscher
- 8.1a: erster Ausgang des Gegenstromwärmetauschers
- 8.1e: erster Eingang des Gegenstromwärmetauschers
- 8.2a: zweiter Ausgang des Gegenstromwärmetauschers
- 8.2e: zweiter Eingang des Gegenstromwärmetauschers
- 9: gekühlte Probenkopfkomponente
- 10: gekühlte Probenkopfkomponente
- 11: NMR-Probenkopf
- 18: Stickstoffbehälter
- 19: Wärmetauscher im Stickstoffbehälter
- 21: zweiter Strahlungsschild
- 22: Wärmetauscher im Kryostatvakuum
- 27: supraleitende Magnetanordnung
- 101: Kaltbohrung des supraleitenden Magnetspulensystems
- 102: Vakuumbehälter des Kryostaten
- 103: Raumtemperaturzugang
- 105: Heliumbehälter
- 110: erster Strahlungsschild
- 111: supraleitendes Magnetspulensystem
- 201: wärmeisolierter Behälter
- 202: Wärmetauscher im Kryostatvakuum
- 203: Wärmetauscher in mit dem Stickstoffbehälter kommunizierendem Behälter
- 204: mit dem Stickstoffbehälter kommunizierender Behälter
- 205: Wärmetauscher in einem Aufhängerohr des Heliumbehälters

### Referenzliste:

Für die Beurteilung der Patentfähigkeit in Betracht gezogene Druckschriften
[1] EP 1 655 616 A1, US 2006/0096301 A1
[2] US 2012/0242335 A1
[3] US 2007/0107445 A1
[4] US 2005/0202976 A1
[5] US 2006/0130493 A1
[6] DE 10 2013 213 020 A1
[7] DE 40 39 129 A1
[8] US 2012/0319690 A1

## Patentansprüche

1. NMR-Apparatur mit einer supraleitenden Magnetanordnung (27) mit einem Kryostaten, welcher einen Vakuumbehälter (102) und eine auf einer Betriebstemperatur < 100K betreibbare Kältestufe umfasst, und mit einem supraleitenden Magnetspulensystem (111) mit einer Kaltbohrung (101), in die ein Raumtemperaturzugang (103) des Kryostaten eingreift, wobei im Betrieb ein NMR-Probenkopf (11) mit auf eine Betriebstemperatur < 100K gekühlten Probenkopfkomponenten (9, 10) vorhanden ist, wobei ein mindestens zweistufiger Kryokühler (2) mit einer zweiten Kühlstufe (4) auf einer Betriebstemperatur < 35,4 K und einer ersten Kühlstufe (3) mit einer Betriebstemperatur über der Betriebstemperatur der zweiten Kühlstufe (4) in einem wärmeisolierten Gehäuse (1) angeordnet ist, wobei im wärmeisolierten Gehäuse (1) ein Gegenstromwärmetauscher (8) mit zwei Eingängen (8.1e, 8.2e) und zwei Ausgängen (8.1a, 8.2a) für zwei gegenläufige Kühlfluidströme vorhanden ist, wobei eine Kühlleitung Kühlfluid von einem Wärmetauscher auf der ersten Kühlstufe (3) des Kryokühlers (2) -direkt oder indirekt- in den ersten Eingang (8.1e) des Gegenstromwärmetauschers (8) leitet, wobei eine Kühlleitung Kühlfluid vom zweiten Ausgang (8.2a) des Gegenstromwärmetauschers (8) -direkt oder indirekt- zu einem Wärmetauscher auf der zweiten Kühlstufe (4) des Kryokühlers (2) leitet, wobei eine Kühlleitung Kühlfluid zu einer gekühlten Probenkopfkomponente (9, 10) oder zu einem Wärmetauscher auf einer gekühlten Probenkopfkomponente (9, 10) leitet, und wobei eine Kühlleitung Kühlfluid zu einem Wärmetauscher (22, 202) im Kryostatvakuum leitet,
**dadurch gekennzeichnet,**
**dass** eine Kühlleitung Kühlfluid -entweder direkt vom zweiten Ausgang (8.2a) des Gegenstromwärmetauschers (8) oder indirekt vom zweiten Ausgang (8.2a) des Gegenstromwärmetauschers (8) über den Wärmetauscher auf der zweiten Kühlstufe (4) des Kryokühlers (2) oder über eine gekühlte Probenkopfkomponente (9) oder über einen Wärmetauscher auf einer gekühlten Probenkopfkomponente (9)- zum Wärmetauscher (202) im Kryostatvakuum oder zu einem Wärmetauscher (205) in einem Aufhängerohr eines Heliumbehälters (105) des Kryostaten und von diesem -entweder direkt oder indirekt über mindestens einen Wärmetauscher auf der zweiten Kühlstufe (4) des Kryokühlers (2) oder über eine gekühlte Probenkopfkomponente (9) oder über den Wärmetauscher auf einer gekühlten Probenkopfkomponente (9)- zum zweiten Eingang (8.2e) des Gegenstromwärmetauschers (8) leitet, so dass sowohl die Einlauftemperatur des in den Wärmetauscher (202) im Kryostatvakuum oder in den Wärmetauscher (205) in einem Aufhängerohr des Heliumbehälters (105) des Kryostaten einströmenden Kühlfluids des Kühlkreislaufs als auch die Rücklauftemperatur des aus diesem Wärmetauscher (202, 205) austretenden Kühlfluids im Betriebszustand der NMR-Apparatur mindestens 5 K tiefer als die Betriebstemperatur der ersten Stufe (3) des Kryokühlers (2) ist.

2. NMR-Apparatur nach Anspruch 1, **dadurch gekennzeichnet, dass** der Kühlkreislauf wärmeisolierte Kühlleitungen außerhalb des wärmeisolierten Gehäuses (1) aufweist, und dass der Vakuumbehälter (102) des Kryostaten gegenüber einem Isolationsvakuum der wärmeisolierten Kühlleitungen des Kühlkreislaufs vakuumdicht verschlossen ist.

3. NMR-Apparatur nach Anspruch 1 oder 2, **dadurch gekennzeichnet, dass** gekühlte Probenkopfkomponenten (9, 10) in einem eigenen wärmeisolierten Behälter (201) des NMR-Probenkopfes (11) innerhalb des Raumtemperaturzugangs (103) des Kryostaten angeordnet sind, und dass wärmeisolierte Kühlleitungen zwischen dem wärmeisolierten Gehäuse (1) des Kryokühlers (2) und den gekühlten Probenkopfkomponenten (9, 10) oder dem Wärmetauscher auf den gekühlten Probenkopfkomponenten (9, 10) sowie dem Wärmetauscher (22, 202) im Kryostatvakuum geführt sind.

4. NMR-Apparatur nach Anspruch 3, **dadurch gekennzeichnet, dass** der Kühlkreislauf Kühlfluid von der zweiten Kühlstufe (4) des Kryokühlers (2) nacheinander an den Wärmetauscher (202) im Kryostatvakuum und dann an eine gekühlte Probenkopfkomponente (9) oder an einen Wärmetauscher auf einer gekühlten Probenkopfkomponenten (9) führt.

5. NMR-Apparatur nach Anspruch 3, **dadurch gekennzeichnet, dass** der Kühlkreislauf Kühlfluid von der zweiten Kühlstufe (4) des Kryokühlers (2) nacheinander an eine gekühlte Probenkopfkomponente (9) oder an den Wärmetauscher auf einer gekühlten Probenkopfkomponente (9) und dann an den Wärmetauscher (202) im Kryostatvakuum führt.

6. NMR-Apparatur nach Anspruch 3, **dadurch gekennzeichnet, dass** der Kühlkreislauf Kühlfluid von der zweiten Kühlstufe (4) des Kryokühlers (2) parallel sowohl an eine gekühlte Probenkopfkomponente (9) oder an den Wärmetauscher auf einer gekühlten Probenkopfkomponente (9) als auch an den Wärmetauscher (202) im Kryostatvakuum führt.

7. NMR-Apparatur nach Anspruch 1 oder 2, **dadurch gekennzeichnet, dass** gekühlte Probenkopfkomponenten (9) mindestens zum Teil in einem Bereich zwischen der Kaltbohrung (101) des supraleitenden Magnetspulensystems (111) und dem Raumtemperaturzugang (103) des Kryostaten in die Kaltbohrung (101) radial innerhalb der Kaltbohrung (101), aber außerhalb des Raumtemperaturzugangs (103) des Kryostaten angeordnet und wärmeleitend mit dem an den Kühlkreislauf angeschlossenen Wärmetauscher (202) im Kryostatvakuum verbunden sind.

8. NMR-Apparatur nach Anspruch 7, **dadurch gekennzeichnet, dass** der an den Kühlkreislauf angeschlossene Wärmetauscher (202) im Kryostatvakuum wärmeleitend sowohl mit gekühlten Probenkopfkomponenten (9) als auch mit einer Kältestufe des Kryostaten verbunden ist.

9. NMR-Apparatur nach einem der vorhergehenden Ansprüche, **dadurch gekennzeichnet, dass** mindestens zwei an den Kühlkreislauf angeschlossene Wärmetauscher (22, 202) im Kryostatvakuum vorhanden sind, wobei die Rücklauftemperatur des von dem an den Kühlkreislauf angeschlossenen Wärmetauscher (22) im Kryostatvakuum kommenden Kühlfluids des Kühlkreislaufs höher ist als die Betriebstemperatur der ersten Kühlstufe (3) des Kryokühlers (2).

10. NMR-Apparatur nach einem der vorhergehenden Ansprüche, **dadurch gekennzeichnet, dass** der an den Kühlkreislauf angeschlossene Wärmetauscher (22, 202, 205) im Kryostatvakuum oder in einem Aufhängerohr des Heliumbehälters (105) des Kryostaten angeordnet und wärmeleitend mit einer Kältestufe des Kryostaten verbunden ist, welche einen Strahlungsschild (21, 110) oder einen Kryogenbehälter (18, 105) umfasst.

11. NMR-Apparatur nach einem der Ansprüche 1 bis 10, **dadurch gekennzeichnet, dass** das supraleitende Magnetspulensystem (111) unmittelbar im Isolationsvakuum des Kryostaten angeordnet ist, und dass ein an den Kühlkreislauf angeschlossener Wärmetauscher (202) im Kryostatvakuum mit dem supraleitenden Magnetspulensystem (111) wärmeleitend verbunden ist, wobei das supraleitende Magnetspulensystem (111) die Supraleitermaterialien MgB2 oder HTS (BSCCO, ReBCO) aufweist.

12. NMR-Apparatur nach einem der Ansprüche 1 bis 6, 9 oder 10, **dadurch gekennzeichnet, dass** gekühlte Probenkopfkomponenten (9, 10) im eigenen wärmeisolierten Behälter (201) innerhalb des Raumtemperatur-zugangs (103) des Kryostaten angeordnet sind, dass der Kryostat den Heliumbehälter (105) zur Aufnahme des supraleitenden Magnetspulensystems (111) und den ersten Strahlungsschild (110) und den Stickstoffbehälter (18) oder den zweiten Strahlungsschild (21) umfasst, und dass der Kühlkreislauf durch den Vakuumbehälter(102) des Kryostaten hindurch zu mindestens zwei Wärmetauschern (22, 202) im Kryostatvakuum geführt ist, wobei der erste an den Kühlkreislauf angeschlossene Wärmetauscher (202) wärmeleitend mit dem ersten Strahlungsschild (110) verbunden ist und die Rücklauftemperatur des von diesem Wärmetauscher (202) kommenden Kühlfluids tiefer als die Betriebstemperatur der ersten Stufe (3) des Kryokühlers (2) ist, und wobei der zweite an den Kühlkreislauf angeschlossene Wärmetauscher (22) wärmeleitend mit dem Stickstoffbehälter (18) oder dem zweiten Strahlungsschild (21) verbunden ist und die Rücklauftemperatur des von diesem Wärmetauscher (22) kommenden Kühlfluids höher als die Betriebstemperatur der ersten Stufe (3) des Kryokühlers (2) ist.

13. NMR-Apparatur nach einem der Ansprüche 1 bis 6, 9 oder 10, **dadurch gekennzeichnet, dass** gekühlte Probenkopfkomponenten (9, 10) im eigenen wärmeisolierten Behälter (201) innerhalb des Raumtemperatur-zugangs (103) des Kryostaten angeordnet sind, dass der Kryostat den Heliumbehälter (105) zur Aufnahme des supraleitenden Magnetspulensystems (111) und den Strahlungsschild (110) und den Stickstoffbehälter (18) umfasst, dass der Kühlkreislauf durch den Vakuumbehälter (102) des Kryostaten hindurch zum Wärmetauscher (202) im Kryostatvakuum geführt ist, welcher wärmeleitend mit dem Strahlungsschild (110) verbunden ist, wobei die Rücklauftemperatur des von diesem Wärmetauscher (202) kommenden Kühlfluids tiefer als die Betriebstemperatur der ersten Stufe (3) des Kryokühlers (2) ist, und dass sich ein zweiter an den Kühlkreislauf angeschlossener Wärmetauscher (19, 203) im Stickstoffbehälter (18) oder in einem mit dem Stickstoffbehälter (18) kommunizierenden Behälter (204) befindet, wobei die Rücklauftemperatur des von diesem Wärmetauscher (19, 203) kommenden Kühlfluids höher als die Betriebstemperatur der ersten Stufe (3) des Kryokühlers (2) ist.

14. NMR-Apparatur nach einem der vorhergehenden Ansprüche, **dadurch gekennzeichnet, dass** die gekühlten Probenkopfkomponenten (9, 10) einen HF-Resonator und/oder einen Vorverstärker umfassen.

## Claims

1. An NMR apparatus comprising a superconducting magnet assembly (27) comprising a cryostat which has a vacuum tank (102) and a refrigeration stage that can be operated at an operating temperature of < 100 K and comprising a superconducting magnet coil system (111) that comprises a cold bore (101) in which a room temperature access (103) of the cryostat engages, an NMR sample head (11) that comprises sample head components (9, 10) cooled to an operating temperature of < 100 K being provided during operation, an at least two-stage cryocooler (2) having a second cooling stage (4) at an operating temperature of < 35.4 K and a first cooling stage (3) having an operating temperature that is greater than the operating temperature of the second cooling stage (4) being arranged in a heat-insulated housing (1), a counter flow heat exchanger (8) comprising two inlets (8.1e, 8.2e) and two outlets (8.1a, 8.2a) for two opposing coolant flows being provided in the heat-insulated housing (1), a cooling line guiding coolant from a heat exchanger on the first cooling stage (3) of the cryocooler (2), directly or indirectly, into the first inlet (8.1e) of the counter flow heat exchanger (8), a cooling line guiding coolant from the second outlet (8.2a) of the counter flow heat exchanger (8), directly or indirectly, to a heat exchanger on the second cooling stage (4) of the cryocooler (2), a cooling line guiding coolant to a cooled sample head component (9, 10) or to a heat exchanger on a cooled sample head component (9, 10), and a cooling line guiding coolant to a heat exchanger (22, 202) in the cryostat vacuum,
**characterized in that**
a cooling line guides coolant, either directly from the second outlet (8.2a) of the counter flow heat exchanger (8) or indirectly from the second outlet (8.2a) of the counter flow heat exchanger (8) via the heat exchanger on the second cooling stage (4) of the cryocooler (2) or
via a cooled sample head component (9) or via a heat exchanger on a cooled sample head component (9), to a heat exchanger (202) in the cryostat vacuum or to a heat exchanger (205) in a suspension tube of a helium tank (105) of the cryostat, and from there, either directly or indirectly via at least one heat exchanger on the second cooling stage (4) of the cyrocooler (2) or via a cooled sample head component (9) or via the heat exchanger on a cooled sample head component (9), to the second inlet (8.2e) of the counter flow heat exchanger (8), such that, in the operating state of the NMR apparatus, both the intake temperature of the coolant of the cooling circuit flowing into the heat exchanger (202) in the cryostat vacuum or into the heat exchanger (205) in a suspension tube of a helium tank (105) of the cryostat and the return flow temperature of the coolant emerging from this heat exchanger (202, 205) are at least 5 K lower than the operating temperature of the first stage (3) of the cryocooler (2).

2. The NMR apparatus according to claim 1, **characterized in that** the cooling circuit comprises heat-insulated cooling lines outside the heat-insulated housing (1), and **in that** the vacuum tank (102) of the cryostat is sealed in a vacuum-tight manner from an insulation vacuum of the heat-insulated cooling lines of the cooling circuit.

3. The NMR apparatus according to either claim 1 or claim 2, **characterized in that** cooled sample head components (9, 10) are arranged in a separate heat-insulated tank (201) of the NMR sample head (11) inside the room temperature access (103) of the cryostat, and **in that** heat-insulated cooling lines are guided between the heat-insulated housing (1) of the cryocooler (2) and the cooled sample head components (9, 10), or between a heat exchanger on the cooled sample head components (9, 10) and the heat exchanger (22, 202) in the cryostat vacuum.

4. The NMR apparatus according to claim 3, **characterized in that** the cooling circuit guides coolant from the second cooling stage (4) of the cryocooler (2) in succession to the heat exchanger (202) in the cryostat vacuum, and then to a cooled sample head component (9) or to a heat exchanger on a cooled sample head component (9).

5. The NMR apparatus according to claim 3, **characterized in that** the cooling circuit guides coolant from the second cooling stage (4) of the cryocooler (2) in succession to a cooled sample head component (9) or to the heat exchanger on a cooled sample head component (9), and then to the heat exchanger (202) in the cryostat vacuum.

6. The NMR apparatus according to claim 3, **characterized in that** the cooling circuit guides coolant from the second cooling stage (4) of the cryocooler (2), in parallel, both to a cooled sample head component (9) or to the heat exchanger on a cooled sample head component (9), and to the heat exchanger (202) in the cryostat vacuum.

7. The NMR apparatus according to either claim 1 or claim 2, **characterized in that** cooled sample head components (9) are arranged, at least in part, in a region between the cold bore (101) of the superconducting magnet coil system (111) and the room temperature access (103) of the cryostat into the cold bore (101), radially inside the cold bore (101) but outside the room temperature access (103) of the cryostat and connected in a heat-conducting manner to a heat exchanger (202) in the cryostat vacuum that is connected to the cooling circuit.

8. The NMR apparatus according to claim 7, **characterized in that** the heat exchanger (202) in the cryostat vacuum that is connected to the cooling circuit is connected in a heat-conducting manner both to cooled sample head components (9) and to a refrigeration stage of the cryostat.

9. The NMR apparatus according to any of the preceding claims, **characterized in that** at least two heat exchangers (22, 202) connected to the cooling circuit are provided in the cryostat vacuum, the return flow temperature of the coolant of the cooling circuit coming from a heat exchanger (22) in the cryostat vacuum that is connected to the cooling circuit being higher than the operating temperature of the first cooling stage (3) of the cryocooler (2).

10. The NMR apparatus according to any of the preceding claims, **characterized in that** the heat exchanger (22, 202, 205) connected to the cooling circuit is arranged in the cryostat vacuum or in a suspension tube of a helium tank (105) of the cryostat and is connected in a heat-conducting manner to a refrigeration stage of the cryostat that comprises a radiation shield (21, 110) or a cryogen tank (18, 105).

11. The NMR apparatus according to any of claims 1 to 10, **characterized in that** the superconducting magnet coil system (111) is directly arranged in the insulation vacuum of the cryostat, and **in that** a heat exchanger (202) in the cryostat vacuum that is connected to the cooling circuit is connected to the superconducting magnet coil system (111) in a heat-conducting manner, the superconducting magnet coil system (111) comprising the superconducting materials MgB2 or HTS (BSCCO, ReBCO).

12. The NMR apparatus according to any of claims 1 to 6, 9 or 10, **characterized in that** cooled sample head components (9, 10) are arranged in a separate heat-insulated tank (201) inside the room temperature access (103) of the cryostat, **in that** the cryostat comprises the helium tank (105) for receiving the superconducting magnet coil system (111), and a first radiation shield (110) and the nitrogen tank (18) or the second radiation shield (21), and **in that** the cooling circuit is guided through the vacuum tank (102) of the cryostat to at least two heat exchangers (22, 202) in the cryostat vacuum, the first heat exchanger (202) that is connected to the cooling circuit being connected in a heat-conducting manner to the first radiation shield (110) and the return flow temperature of the coolant coming from this heat exchanger (202) being lower than the operating temperature of the first stage (3) of the cryocooler (2), and the second heat exchanger (22) that is connected to the cooling circuit being connected in a heat-conducting manner to the nitrogen tank (18) or to the second radiation shield (21) and the return flow temperature of the coolant coming from this heat exchanger (22) being higher than the operating temperature of the first stage (3) of the cryocooler (2).

13. The NMR apparatus according to any of claims 1 to 6, 9 or 10, **characterized in that** cooled sample head components (9, 10) are arranged in a separate heat-insulated tank (201) inside the room
temperature access (103) of the cryostat, **in that** the cryostat comprises the helium tank (105) for receiving the superconducting magnet coil system (111), and the radiation shield (110) and the nitrogen tank (18), **in that** the cooling circuit is guided through the vacuum tank (102) of the cryostat to the heat exchanger (202) in the cryostat vacuum that is connected in a heat-conducting manner to the radiation shield (110), the return flow temperature of the coolant coming from this heat exchanger (202) being lower than the operating temperature of the first stage (3) of the cryocooler (2), and **in that** a second heat exchanger (19, 203) that is connected to the cooling circuit is located in the nitrogen tank (18) or in a
tank (204) that communicates with the nitrogen tank (18), the return flow
temperature of the coolant coming from this heat exchanger (19, 203) being higher than the operating temperature of the first stage (3) of the cryocooler (2).

14. The NMR apparatus according to any of the preceding claims, **characterized in that** the cooled sample head components (9, 10) comprise an HF resonator and/or a pre-amplifier.

## Revendications

1. Appareil de RMN comportant un agencement d'aimants supraconducteurs (27) avec un cryostat qui comprend un récipient sous vide (102) et un étage de refroidissement pouvant fonctionner à une température de fonctionnement < 100 K, et comportant un système de bobines d'aimants supraconducteurs (111) avec un alésage froid (101) dans lequel pénètre un accès à la température ambiante (103) du cryostat, dans lequel, en fonctionnement, une tête de sonde RMN (11) avec des composants de tête de sonde (9, 10) refroidis à une température de fonctionnement < 100 K est présente, dans lequel un cryorefroidisseur (2) à au moins deux étages avec un deuxième étage de refroidissement (4) à une température de fonctionnement < 35,4 K et un premier étage de refroidissement (3) à une température de fonctionnement supérieure à la température de fonctionnement du deuxième étage de refroidissement (4) est disposé dans une enceinte thermiquement isolée (1), dans lequel un échangeur de chaleur (8) à contre-courant avec deux entrées (8.1e, 8.2e) et deux sorties (8.1a, 8.2a) pour deux courants de fluide de refroidissement opposés est présent dans l'enceinte thermiquement isolée (1), dans lequel une conduite de refroidissement conduit du fluide de refroidissement d'un échangeur de chaleur au premier étage de refroidissement (3) du cryorefroidisseur (2) - directement ou indirectement - dans la première entrée (8.1e) de l'échangeur de chaleur à contre-courant (8), dans lequel une conduite de refroidissement conduit du fluide de refroidissement de la deuxième sortie (8.2a) de l'échangeur de chaleur à contre-courant (8) - directement ou indirectement - à un échangeur de chaleur au deuxième étage de refroidissement (4) du cryorefroidisseur (2), dans lequel une conduite de refroidissement conduit du fluide de refroidissement à un composant de tête de sonde refroidi (9, 10) ou à un échangeur de chaleur sur un composant de tête de sonde refroidi (9, 10) et dans lequel une conduite de refroidissement conduit du fluide de refroidissement à un échangeur de chaleur (22, 202) dans le vide du cryostat,
**caractérisé en ce**
**qu'**une conduite de refroidissement conduit du fluide de refroidissement - soit directement de la deuxième sortie (8.2a) de l'échangeur de chaleur à contre-courant (8), soit indirectement de la deuxième sortie (8.2a) de l'échangeur de chaleur à contre-courant (8) par l'intermédiaire de l'échangeur de chaleur au deuxième étage de refroidissement (4) du cryorefroidisseur (2) ou par l'intermédiaire d'un composant de tête de sonde refroidi (9) ou par l'intermédiaire d'un échangeur de chaleur sur un composant de tête de sonde refroidi (9) - à l'échangeur de chaleur (202) dans le vide du cryostat ou à un échangeur de chaleur (205) dans un tube de suspension d'un réservoir d'hélium (105) du cryostat et de celui-ci - soit directement, soit indirectement par l'intermédiaire d'au moins un échangeur de chaleur au deuxième étage de refroidissement (4) du cryorefroidisseur (2) ou par l'intermédiaire d'un composant de tête de sonde refroidi (9) ou par l'intermédiaire de l'échangeur de chaleur sur un composant de tête de sonde refroidi (9) - à la deuxième entrée (8.2e) de l'échangeur de chaleur à contre-courant (8), de telle sorte que tant la température d'entrée du fluide de refroidissement du circuit de refroidissement s'écoulant dans l'échangeur de chaleur (202) dans le vide du cryostat ou dans l'échangeur de chaleur (205) dans un tube de suspension du réservoir d'hélium (105) du cryostat, que la température de retour du fluide de refroidissement du circuit de refroidissement sortant de cet échangeur de chaleur (202, 205) soit inférieure d'au moins 5 K à la température de fonctionnement du premier étage (3) du cryorefroidisseur (2) dans l'état de fonctionnement de l'appareil de RMN.

2. Appareil de RMN selon la revendication 1, **caractérisé en ce que** le circuit de refroidissement présente des conduites de refroidissement thermiquement isolées à l'extérieur de l'enceinte thermiquement isolée (1), et que le récipient sous vide (102) du cryostat est fermé de manière étanche au vide par rapport à un vide d'isolation des conduites de refroidissement thermiquement isolées du circuit de refroidissement.

3. Appareil de RMN selon la revendication 1 ou 2, **caractérisé en ce que** des composants de tête de sonde refroidis (9, 10) sont disposés dans leur propre récipient thermiquement isolé (201) de la tête de sonde RMN (11) à l'intérieur de l'accès à la température ambiante (103) du cryostat, et que des conduites de refroidissement thermiquement isolées sont guidées entre l'enceinte thermiquement isolée (1) du cryorefroidisseur (2) et les composants de tête de sonde refroidis (9, 10) ou l'échangeur de chaleur sur les composants de tête de sonde refroidis (9, 10) ainsi que l'échangeur de chaleur (22, 202) dans le vide du cryostat.

4. Appareil de RMN selon la revendication 3, **caractérisé en ce que** le circuit de refroidissement conduit du fluide de refroidissement du deuxième étage de refroidissement (4) du cryorefroidisseur (2) successivement à l'échangeur de chaleur (202) dans le vide du cryostat puis à un composant de tête de sonde refroidi (9) ou à un échangeur de chaleur sur un composant de tête de sonde refroidi (9).

5. Appareil de RMN selon la revendication 3, **caractérisé en ce que** le circuit de refroidissement conduit du fluide de refroidissement du deuxième étage de refroidissement (4) du cryorefroidisseur (2) successivement à un composant de tête de sonde refroidi (9) ou à l'échangeur de chaleur sur un composant de tête de sonde refroidi (9) puis à l'échangeur de chaleur (202) dans le vide du cryostat.

6. Appareil de RMN selon la revendication 3, **caractérisé en ce que** le circuit de refroidissement conduit du fluide de refroidissement du deuxième étage de refroidissement (4) du cryorefroidisseur (2) en parallèle à la fois à un composant de tête de sonde refroidi (9) ou à l'échangeur de chaleur sur un composant de tête de sonde refroidi (9) et à l'échangeur de chaleur (202) dans le vide du cryostat.

7. Appareil de RMN selon la revendication 1 ou 2, **caractérisé en ce que** des composants de tête de sonde refroidis (9) sont disposés au moins en partie dans une zone entre l'alésage froid (101) du système de bobines d'aimants supraconducteurs (111) et l'accès à la température ambiante (103) du cryostat dans l'alésage froid (101) radialement à l'intérieur de l'alésage froid (101), mais à l'extérieur de l'accès à la température ambiante (103) du cryostat, et sont reliés de manière thermoconductrice à l'échangeur de chaleur (202) raccordé au circuit de refroidissement dans le vide du cryostat.

8. Appareil de RMN selon la revendication 7, **caractérisé en ce que** l'échangeur de chaleur (202) raccordé au circuit de refroidissement dans le vide du cryostat est relié de manière thermoconductrice à la fois à des composants de tête de sonde refroidis (9) et à un étage de refroidissement du cryostat.

9. Appareil de RMN selon l'une des revendications précédentes, **caractérisé en ce qu'**au moins deux échangeurs de chaleur (22, 202) raccordés au circuit de refroidissement sont présents dans le vide du cryostat, la température de retour du fluide de refroidissement du circuit de refroidissement venant de l'échangeur de chaleur (22) raccordé au circuit de refroidissement dans le vide du cryostat étant supérieure à la température de fonctionnement du premier étage de refroidissement (3) du cryorefroidisseur (2).

10. Appareil de RMN selon l'une des revendications précédentes, **caractérisé en ce que** l'échangeur de chaleur (22, 202, 205) raccordé au circuit de refroidissement est disposé dans le vide du cryostat ou dans un tube de suspension du réservoir d'hélium (105) du cryostat et relié de manière thermoconductrice à un étage de refroidissement du cryostat qui comprend un écran anti-rayonnement (21, 110) ou un récipient cryogénique (18, 105).

11. Appareil de RMN selon l'une des revendications 1 à 10, **caractérisé en ce que** le système de bobines d'aimants supraconducteurs (111) est disposé directement dans le vide d'isolation du cryostat, et qu'un échangeur de chaleur (202) raccordé au circuit de refroidissement dans le vide du cryostat est relié de manière thermoconductrice au système de bobines d'aimants supraconducteurs (111), le système de bobines d'aimants supraconducteurs (111) présentant les matériaux supraconducteurs MgB2 ou HTS (BSCCO, ReBCO).

12. Appareil de RMN selon l'une des revendications 1 à 6, 9 ou 10, **caractérisé en ce que** des composants de tête de sonde refroidis (9, 10) sont disposés dans leur propre récipient thermiquement isolé (201) à l'intérieur de l'accès à la température ambiante (103) du cryostat, que le cryostat comprend le réservoir d'hélium (105) destiné à recevoir le système de bobines d'aimants supraconducteurs (111) et le premier écran anti-rayonnement (110) et le réservoir d'azote (18) ou le deuxième écran anti-rayonnement (21), et que le circuit de refroidissement est guidé à travers le récipient sous vide (102) du cryostat vers au moins deux échangeurs de chaleur (22, 202) dans le vide du cryostat, dans lequel le premier échangeur de chaleur (202) raccordé au circuit de refroidissement est relié de manière thermoconductrice au premier écran anti-rayonnement (110) et la température de retour du fluide de refroidissement venant de cet échangeur de chaleur (202) est inférieure à la température de fonctionnement du premier étage (3) du cryorefroidisseur (2), et dans lequel le deuxième échangeur de chaleur (22) raccordé au circuit de refroidissement est relié de manière thermoconductrice au réservoir d'azote (18) ou au deuxième écran anti-rayonnement (21) et la température de retour du fluide de refroidissement venant de cet échangeur de chaleur (22) est supérieure à la température de fonctionnement du premier étage (3) du cryorefroidisseur (2).

13. Appareil de RMN selon l'une des revendications 1 à 6, 9 ou 10, **caractérisé en ce que** les composants de tête de sonde refroidis (9, 10) sont disposés dans leur propre récipient thermiquement isolé (201) à l'intérieur de l'accès à la température ambiante (103) du cryostat, que le cryostat comprend le réservoir d'hélium (105) destiné à recevoir le système de bobines d'aimants supraconducteurs (111), l'écran anti-rayonnement (110) et le réservoir d'azote (18), que le circuit de refroidissement est guidé à travers le récipient sous vide (102) du cryostat vers l'échangeur de chaleur (202) dans le vide du cryostat, lequel est relié de manière thermoconductrice à l'écran anti-rayonnement (110), la température de retour du fluide de refroidissement venant de cet échangeur de chaleur (202) étant inférieure à la température de fonctionnement du premier étage (3) du cryorefroidisseur (2), et qu'un deuxième échangeur de chaleur (19, 203) raccordé au circuit de refroidissement se trouve dans le réservoir d'azote (18) ou dans un récipient (204) communiquant avec le réservoir d'azote (18), la température de retour du fluide de refroidissement venant de cet échangeur de chaleur (19, 203) étant supérieure à la température de fonctionnement du premier étage (3) du cryorefroidisseur (2).

14. Appareil de RMN selon l'une des revendications précédentes, **caractérisé en ce que** les composants de tête de sonde refroidis (9, 10) comprennent un résonateur RF et/ou un préamplificateur.
